# EUROPEAN PATENT APPLICATION

(11) **EP 2 194 429 A1**
(43) Date of publication of application: **09.06.2010**
(21) Application number: 08170523.8
(22) Date of filing: 02.12.2008
(51) Int. Cl.: G03F 7/32, G03F 7/40, B41N 3/08

(54) **Gumming compositions with nano-particles for improving scratch sensitivity in image and non-image areas of lithographic printing plates**

(71) Applicant: Eastman Kodak Company, Rochester NY 14650-2201 (US)
(72) Inventor: Savariar-Hauck, Celin, 37534 Badenhausen (DE); Pengler, Joachim, 85540 Haar (DE)
(74) Representative: Vossius & Partner

(57) **Abstract**

The process for improving the scratch-resistance of a lithographic printing plate, comprising: applying an aqueous composition comprising inorganic, non-metallic, inert particles having an average particle size of from 1 nm to 0.5 µm, to an exposed and optionally developed lithographic printing plate precursor.

## Description

The present invention relates to a process for gumming lithographic printing plates, in particular a process using a gumming composition containing inert nano-particles. Furthermore, the invention relates to gumming compositions for gumming imaged lithographic printing plates.

The technical field of lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. The printing ink in the image area is then transferred to the surface of a material such as paper, fabric and the like, on which the image is to be formed. Generally, however, the printing ink is first transferred to an intermediate material, referred to as blanket, which then in turn transfers the printing ink onto the surface of the material on which the image is to be formed; this technique is referred to as offset lithography.

A frequently used type of lithographic printing plate precursor comprises a photosensitive coating applied onto a substrate on aluminum basis. The coating can react to radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, i.e. is oleophilic, and the non-image area (background) accepts water, i.e. is hydrophilic. The differentiation between image and non-image areas takes place during exposure, for which a film is attached to the printing plate precursor under vacuum in order to guarantee good contact. The plate is then exposed by means of a radiation source part of which is comprised of UV radiation. When a positive plate is used, the area on the film corresponding to the image on the plate is so opaque that the light does not reach the plate, while the area on the film corresponding to the non-image area is clear and allows light to permeate the coating, whose solubility increases. In the case of a negative plate, the opposite takes place: The area on the film corresponding to the image on the plate is clear, while the non-image area is opaque. The coating beneath the clear film area is hardened due to the incident light, while the area not affected by the light is removed during developing. The light-hardened surface of a negative working plate is therefore oleophilic and accepts printing ink, while the non-image area that used to be coated with the coating removed by the developer is desensitized and therefore hydrophilic.

Alternatively, the plate can also be image-wise exposed digitally without a film. Since the late 1990s plate precursors with heat-sensitive layers are developed wherein by image-wise direct heating or irradiation with IR radiation that is converted into heat, differences in the developer solubility of the heated and unheated areas of the coating are generated; such plates are often referred to as "IR plates" or "thermo plates". According to recent developments plate precursors have been developed which can be imaged by imagewise exposing them to near UV radiation or VIS radiation emitted by a UV laser (including 2-photon excitation systems).

For a clean printed image it is necessary - independent from the type of precursor used - that the image areas (i.e. the image-wise remaining coating) accept the printing ink well, while the non-image areas (i.e. the image-wise revealed substrate, such as e.g. an aluminum substrate) should not accept the printing ink. In order to protect the image-wise revealed substrate, such as e.g. an aluminum substrate, against fingerprints, the formation of aluminum oxide, corrosion and mechanical attacks, such as scratches, when the printing plate is mounted on the press or stored for a certain time, i.e. to maintain and possible improve the hydrophilic nature of the non-image areas, the developed printing plate is usually subjected to a "gumming" treatment (also referred to as "desensitizing" or "finishing"). Gumming the plate prior to storing it or before long periods of standstill of the printing machine ensures that the non-image areas remain hydrophilic. When printing is started, the gumming solution has to be able to be washed off the plate quickly with the fountain solution so that the image areas are capable of accepting ink immediately. Gumming solutions have been known for a long time. The first gumming solutions were based on gum arabic and also nowadays gum arabic is widely used. Years ago attempts were made to find polymeric gum substitutes as there are only limited resources of gum arabic. Since polymer solutions with some types of plates may cause blinding problems attempts were made to remove the polymers from the desensitizing compositions resulting in solutions of particular salts like phosphate salts and optionally surfactants. In other attempts sugars and dextrin type materials often replaced the phosphate salts.

DE 29 26 645 A1 describes a process for the production of a gumming solution for offset printing plates which comprises gum arabic. According to this process, an acidic solution of gum arabic (pH 2 or less) is heated and the pH value is then adjusted to a value of preferably 4.5 to 4.7 by the addition of alkali hydroxide.

DE 20 42 217 A1 discloses the treatment of a planographic printing plate with an aqueous solution whose pH value is between 1 and 5. The solution comprises alkali metal polyphosphate, phosphoric acid or citric acid and a salt selected from sodium or potassium nitrate, perchlorate, permanganate or persulfate.

US 4,880,555 A1 describes a finisher for lithographic printing plates comprising maltodextrin prepared by enzymatic hydrolysis, a polyol, hydrocarbons, a mixture of long-chain alcohols and aminated alcohol sulfate, substituted phenoxypoly(oxyethylene) ethanol and an ethanolamine, and having a pH value in the range of 2.5 to 6.5.

US 4,033,919 A1 describes an aqueous gumming solution comprising a polymer that contains units derived from acrylamide and 1 to 25 wt.-% units with carboxyl groups. The solution furthermore comprises an acidic material which adjusts the pH value of the solution to a value below 5.5; examples thereof include phosphoric acid, citric acid and tartaric acid.

A finisher in the form of an emulsion is described in US 4,162,920 A1. The emulsion comprises an aqueous phase containing tapioca dextrin, a salt that is non-corrosive to aluminum and water, and a solvent phase containing a hydrocarbon solvent and a surfactant soluble therein. The pH value is given as 3 to 5.

In EP 0 397 407 A2 a finisher composition for lithographic printing plates is described which comprises a water-soluble film-forming resin as well as a compound selected from acetylene alcohol, acetylene glycol and an adduct of an alkylene oxide with said alcohol or glycol.

A lithographic plate finisher comprising (a) a cold water soluble dextrine or polyvinylpyrrolidone, (b) at least one non-ionic surfactant with a HLB of 12-18, (c) a humectant, (d) an inorganic salt and (e) water is claimed in EP 0 024 298 A2.

DE 25 30 502 A1 discloses a method, an apparatus and a liquid for simultaneously developing and gumming negative working printing plate; the liquid is said to be water based and contains a smaller amount of organic solvent as well as a water-soluble colloid and has a pH between 3 and 11.

In DE 25 04 594 A1 an aqueous desensitizer solution is described which contains a polymer comprising acrylamide units and units with COOH groups as well as an acidic desensibilizing material like phosphoric acid.

EP 1 868 036 A1 deals with a method for processing of photopolymer printing plates with overcoat. The aqueous alkaline processing liquid comprises water, at least one surfactant, at least one water-soluble film forming hydrophilic polymer and at least one alkaline reagent for adjusting the pH to a value of 9.5 to 14; by the use of said processing liquid removing the overcoat, developing and gumming is carried out in one single process step.

JP 2001-092153 A describes an emulsion type plate surface protecting agent for planographic printing plates which is capable of preventing the edge contamination of a plate in planographic printing on paper having a larger size than the plate; the protecting agent comprises soybean polysaccharides, a modified starch and phosphoric acid and/or phosphate.

JP 2002-079777 A discloses a plate surface protecting agent which is excellent in preventing flaw scumming and oil/fat scumming; the agent comprises at least one member selected from dimethyl sulfoxide, urea, thiourea, guanidine and derivatives thereof.

As mentioned above scratches on the plates often occur during handling subsequent to processing (for instance when plates are stacked or moved for storage while waiting for the press job, or when mounting them on the press) and result in undesired toning on press. With the increasing use of highly automated plate setters and processing units the complaints relating to toning caused by scratches have also increased. One reason is for instance the fact that nowadays press rooms work with less personnel and the intervals when plates are moved are often longer; also, scratches become an increasing issue when larger stacks are moved.

It is therefore the object of the present invention to provide a process which can improve the scratch resistance of imaged lithographic plates while at the same time the hydrophilic nature of the non-image areas of lithographic printing plates during storage and long periods of standstill of the printing press, is maintained.

This object is achieved by a process comprising:
applying an aqueous composition comprising
   inorganic, non-metallic, inert particles having an average particle size of from 1 nm to 0.5 µm, to an exposed and optionally developed lithographic printing plate precursor.

According to one embodiment, an imagewise exposed lithographic printing plate precursor is developed with an aqueous alkaline developer containing at least one film forming polymer and the inorganic, non-metallic, inert particles having an average particle size of from 1 nm to 0.5 µm.

According to another embodiment an imaged lithographic printing plate (i.e. a plate obtained by exposing a precursor to radiation and developing) is treated with a gumming solution which contains the nano-particles and at least one member selected from surfactants and hydrophilic film forming polymers.

The term "printing plate precursor" as used in the present invention relates to an unimaged plate (i.e. that has not been image-wise exposed and developed) from which a printing plate is produced by image-wise exposure and developing. The term "printing plate" (also referred to as "printing form") as used in the present invention refers to an already imaged plate produced from a printing plate precursor.

"Nanoparticles" used in the present invention refers to particles having an average particle size of 1 nm to 0.5 µm.

Within the present invention "gumming composition", "finisher composition" and "desensitzer composition" are used interchangeable.

Within the present invention the use of the articles "a", "an" and "the" is not necessarily meant to refer to only a single compound.

The term "developing" as used in the present invention relates to the removal of the non-image areas of the radiation sensitive precursor coating after exposure to radiation by an aqueous alkaline developer solution.

"One-step-processing" or "2 in 1 processing" refers to a process where developing and gumming are carried out in a single step by using a suitable liquid composition.

In principle any available gumming composition (or "2 in 1 processing composition") can be used in the process of the present invention if it is modified by adding inorganic, non-metallic, inert particles having an average particle size of from 1 nm to 0.5 µm.

Any embodiment, preferred range etc. described below can be combined with one or more other embodiments, preferred ranges etc. described below. All such possible combinations are considered to be within the scope of the present disclosure, even if they are not explicitly mentioned.

Basically, all types of lithographic printing plates can be used in the processes according to the present invention which should be protected by gumming for storage or a standstill of the printing press in order to maintain the hydrophilic nature of the background areas. Both printing plates produced from positive working precursors and printing plates produced from negative working precursors can be used; printing plates that are imaged with UV/VIS radiation and printing plates that are imaged with IR radiation or direct heat can be used. Lithographic printing plates produced by an electro-photographic process may also be used for the present invention if a protection by gumming is desired. In the following, some types of precursors are explained in more detail, however, it is not intended to limit the present invention to these types.

### PRECURSORS

The printing plate precursors can be a negative working precursor as well as a positive working precursor; according to one embodiment the precursors are sensitive to UV/VIS radiation, according to another embodiment the precursors are sensitive to IR radiation or direct heat application. Any type of precursor, especially the examples of suitable precursors described in the following, can be combined with any embodiment of the nanoparticle containing composition (e.g. any embodiment with respect to the developer/gumming composition) described below.

### Substrates

The substrate used for the precursors is preferably a dimensionally stable plate or foil-shaped material like one that has already been used as a substrate for printing matter. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred since it shows a remarkable degree of dimensional stability, is inexpensive and furthermore exhibits excellent adhesion to the radiation-sensitive coating. Furthermore, a composite film can be used wherein an aluminum foil has been laminated onto a plastic film, such as e.g. a polyethylene terephthalate film, or paper, or a plastic film onto which aluminum has been applied by means of vapor deposition. Preferred substrates are metal substrates, wherein the term "metal substrate" as used herein also encompasses composite films with the upper-most layer being a metal layer or foil.

A metal substrate, in particular an aluminum substrate, is preferably subjected to a surface treatment, for example graining by brushing in a dry state or brushing with abrasive suspensions, or electrochemical graining, e.g. by means of a hydrochloric acid electrolyte or HNO₃, and optionally anodizing, e.g. in sulfuric acid or phosphoric acid. According to a preferred embodiment the metal substrate comprises an Al₂O₃-, ZnO-, SiO₂- or TiO₂-layer wherein layer in this connection does not necessarily mean a totally continuous layer over the whole surface of the substrate.

An aluminum foil which preferably has a thickness of 0.1 to 0.7 mm, more preferred 0.15 to 0.5 mm, is an especially preferred substrate. It is preferred that the foil be grained (preferably electrochemically) and then show an average roughness of 0.2 to 1 µm, especially preferred 0.3 to 0.8 µm.

Ths substrate can also be a cylindrical surface having the imageable coating thereon, and thus be an integral part of a printing press. The use of such imaging cylinders is described for example in US 5,713,287.

According to an especially preferred embodiment, the grained aluminum foil was furthermore anodized. The layer weight of the resulting aluminum oxide is preferably 1.5 to 5 g/m², especially preferred 2 to 4 g/m².

A metal substrate can additionally be subjected to a posttreatment (so called "sealing") with an aqueous solution of e.g. alkali metal silicate, calcium zirconium fluoride, hexafluorosilicic acid, phosphate/fluoride, polyvinylphosphonic acid, vinylphosphonic acid copolymers, or phosphonic acid thereby providing a hydrophilizing layer (also referred to as "interlayer") on its surface; the substrate may also be treated with a phosphate solution that may further contain an inorganic fluoride.
The backside (non-imaging side) of the substrate may be coated with antistatic agents and/or slipping layers or a matte layer to improve handling and "feel" of the imageable element.

The details of the above-mentioned substrate treatments are well known to the person skilled in the art.

### Negative working radiation-sensitive elements

Negative working coatings are described in numerous references, e.g. UV-sensitive coatings on the basis of negative diazo resins are described in EP 0 752 430 B1, photopolymer layers sensitive to 405 nm are described in DE 103 07 451, photopolymer layers sensitive to VIS are described in EP 0 684 522 B1 and IR-sensitive polymerizable systems are described in DE 199 06 823 A1.

### PHOTOPOLYMERIZARION (UV/VIS AND IR)

One type of negative working coating applied onto a substrate comprises (a) at least one absorber component selected from photoinitiators and sensitizer/coinitiator systems which absorbs radiation of a wavelength in the range of 250 to 1,200 nm and is capable of initiating a free-radical polymerization, (b) a free-radical polymerizable monomer, oligomers and/or prepolymer, and optionally (c) at least one polymeric binder.

### Absorber component

The radiation-sensitive coating furthermore comprises at least one absorber component selected from photoinitiators and sensitizer/coinitiator systems.

The absorber component is selected such that it is capable of significant absorption in the range in which the radiation source to be used later on during imaging emits; preferably, the absorber shows an absorption maximum in that range. Thus, if the radiation-sensitive element is e.g. going to be imaged by means of an IR laser, the absorber should essentially absorb radiation in the range of about 750 to 1,200 nm and preferably show an absorption maximum in that range. On the other hand, if imaging is to be carried out by means of UV/VIS radiation, the absorber should essentially absorb radiation in the range of about 250 to 750 nm and preferably show an absorption maximum in that range. Suitable photoinitiators and/or sensitizers are known to the person skilled in the art, or it can easily be determined whether significant absorption occurs in the desired wave length range by means of simple tests (e.g. recording an absorption spectrum).

In the present invention, a photoinitiator is a compound capable of absorbing radiation when exposed and of forming free radicals by itself, i.e. without the addition of coinitiators. Examples of suitable photoinitiators absorbing UV or VIS radiation include triazine derivatives with 1 to 3 CX₃ groups (wherein every X is independently selected from a chlorine or bromine atom, and is preferably a chlorine atom), hexaarylbisimidazole compounds, benzoin ethers, benzil ketals, oxime ethers, oxime esters, α-hydroxy- or α-amino-acetophenones, acylphosphines, acylphosphine oxides, acylphosphine sulfides, metallocenes, peroxides etc. Examples of suitable triazine derivatives include 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloromethyl)-s-triazine, and 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine. Suitable oxime ethers and oxide esters are for example those derived from benzoin. Preferred metallocenes are for example titanocenes with two five-membered cyclodienyl groups such as e.g. cyclopentadienyl groups and one or two six-membered aromatic groups having at least one ortho-fluorine atom and optionally also one pyrryl group; most preferred metallocenes are bis(cyclopentadienyl)-bis-[2,6-difluoro-3-(pyrr-1-yl)-phenyl]titanium and dicyclopentadiene-bis-2,4,6-trifluorophenyl-titanium or zirconium.

In the present invention, a single photoinitiator or a mixture of two or more can be used.

The photoinitiators can be used alone or in combination with one or more coinitiators; the addition of coinitiators can increase the effectiveness of the photoinitiation.

The amount of photoinitiator(s) is not particularly restricted; however, if photoinitiators are present, it is preferably in the range of 0.2 to 25 wt-%, based on the dry layer weight, especially preferred 0.5 to 15 wt-%.

A sensitizer as referred to in the present invention is a compound which can absorb radiation when it is exposed but which *cannot* by itself, i.e. without the addition of coinitiators, form free radicals.

All light-absorbing compounds that are photooxidizable or photoreducible or capable of transferring their excitation energy to receptor molecules are suitable sensitizers for use in the present invention. Examples of such dyes include cyanine dyes, merocyanine dyes, oxonol dyes, diarylmethane dyes, triarylmethane dyes, xanthene dyes, coumarin derivatives, ketocoumarin dyes, acridine dyes, phenazine dyes, quinoxaline dyes, pyrrylium dyes or thiapyrrylium dyes, azaanulene dyes (such as phthalocyanines and porphyrines), indigo dyes, anthraquinone dyes, polyarylenes, polyarylpolyenes, 2,5-diphenylisobenzofuranes, 2,5-diarylfuranes, 2,5-diarylthiofuranes, 2,5-diarylpyrroles, 2,5-diarylcyclopentadienes, polyarylphenylenes, polyaryl-2-pyrazolines, carbonyl compounds such as aromatic ketones or quinones, e.g. benzophenone derivatives, Michler's ketone, thioxanthone derivatives, anthraquinone derivatives and fluorenone derivatives.

Coumarin sensitizers of formula (I) as disclosed in WO 2004/049068 A1 are for example suitable for the UV range of the electromagnetic spectrum:

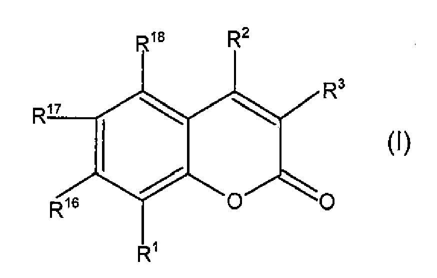

Furthermore, bisoxazole derivatives and analogues of the formula (II) as disclosed in WO 2004/074929 A2 are suitable for the UV range 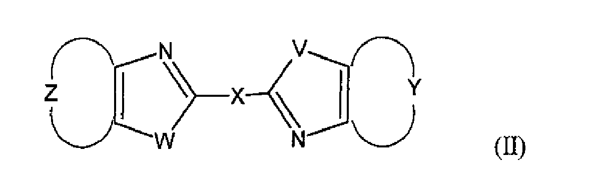 and oxazole compounds of the formula (III) 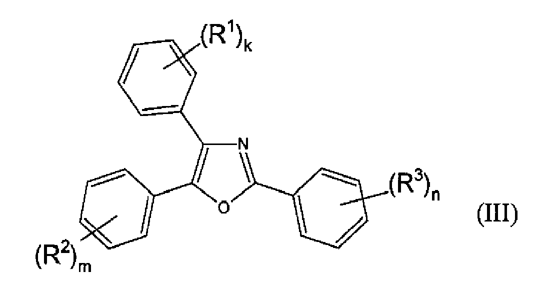 as described in detail in WO 2004/074930 A2 are also suitable.

The 1,4-dihydropyridine compounds of formula (IV) as described in WO 2004/111731 A1 are an example of another class of sensitizers suitable for the UV range

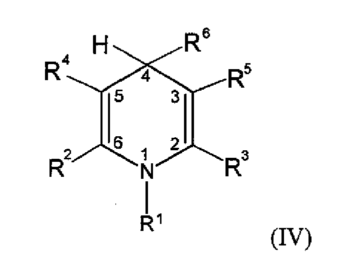

The sensitizers of formulas (V), (VI) disclosed in WO 2006/053689, (VII) disclosed in DE 10 2004 022 137 B3, and (VIII) disclosed in WO 2007/090550 are also suitable for UV sensitive elements; they are especially suitable for plates imaged by 30 µm (and lower) FM screening (FM = frequency-modulated):

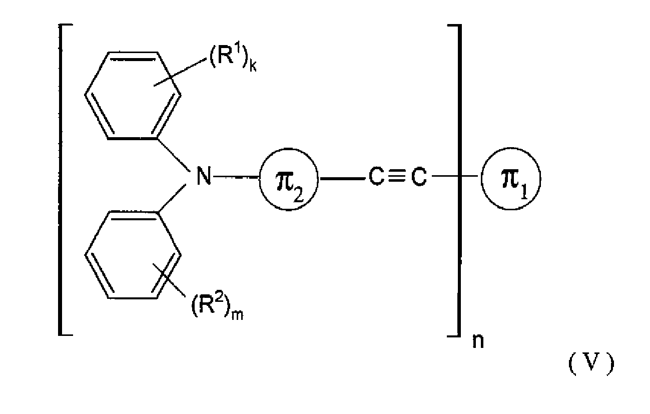

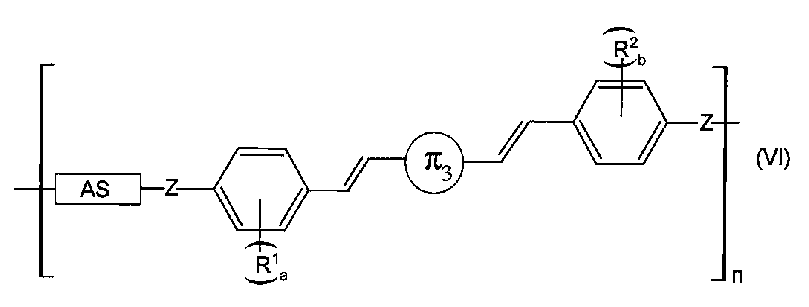

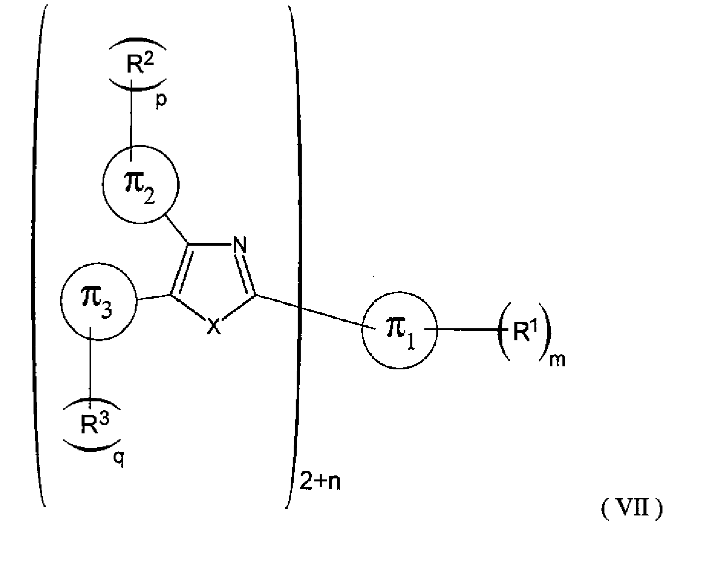

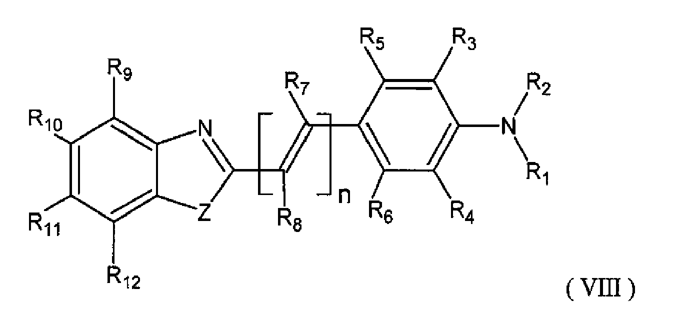

If the radiation-sensitive elements are to be exposed with VIS laser diodes, the cyanopyridone derivatives described in WO 03/069411 A1 are for example suitable as sensitizers.

For IR-sensitive elements, the sensitizers are for example selected from carbon black, phthalocyanine pigments/dyes and pigments/dyes of the polythiophene, squarylium, thiazolium, croconate, merocyanine, cyanine, indolizine, pyrylium or metaldithiolin classes, especially preferred from the cyanine class. The compounds mentioned in Table 1 of US 6,326,122 for example are suitable IR absorbers. Further examples can be found in US 4,327,169, US 4,756,993, US 5,156,938, WO 00/29214, US 6,410,207 and EP 1 176 407 A1.

According to one embodiment, a cyanine dye of formula (IX) 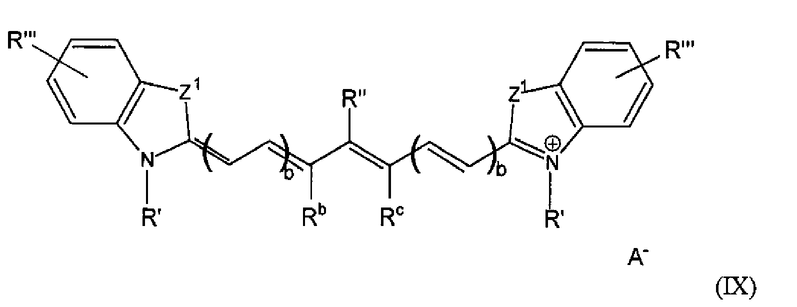 is used, wherein
each Z¹ independently represents S, O, NR^{a} or C(alkyl)₂;
each R¹ independently represents an alkyl group, an alkylsulfonate group or an alkylammonium group;
R" represents a halogen atom, SR^{a}, OR^{a}, SO₂R^{a} or NR^{a}₂;
each R"' independently represents a hydrogen atom, an alkyl group, -COOR^{a}, -OR^{a}, -SR^{a}, -NR^{a}₂ or a halogen atom; R'" can also be a benzofused ring;
A⁻ represents an anion;
R^{b} and R^{c} either both represent hydrogen atoms or, together with the carbon atoms to which they are bonded, form a carbocyclic five- or six-membered ring;
R^{a} represents a hydrogen atom, an alkyl or aryl group;
each b is independently 0, 1, 2 or 3.

If R' represents an alkylsulfonate group, an internal salt can form so that no anion A⁻ is necessary. If R' represents an alkylammonium group, a second counterion is needed which is the same as or different from A⁻.

Of the IR dyes of formula (IX), dyes with a symmetrical structure are especially preferred. Examples of especially preferred dyes include:
2-[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-timethyl-2H-indole-2-ylidene)-ethylidene]-1-cyclohexene-1-yl]-ethenyl]-1,3,3-trimethyl-3H-indolium chloride,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indolium tosylate,
2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium tosylate and
2-[2-[2-chloro-3-[2-ethyl-(3H-benzthiazole-2-ylidene)-ethylidene]-1-cyclohexene-1-yl]-ethenyl]-3-ethyl-benzthiazolium tosylate.

The following compounds are also IR absorbers suitable for the present invention:

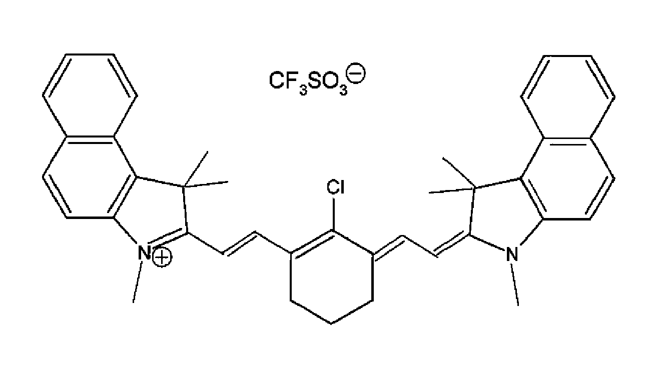

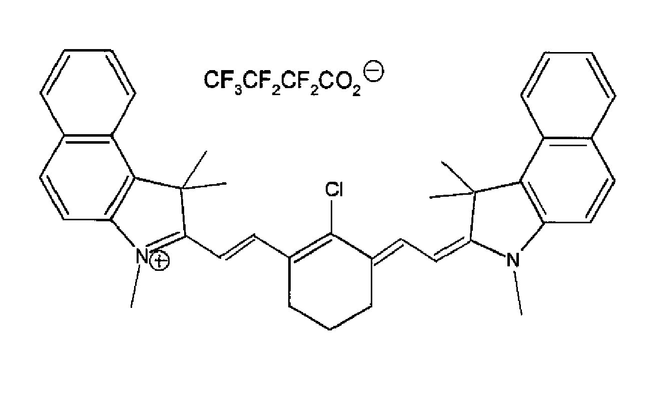

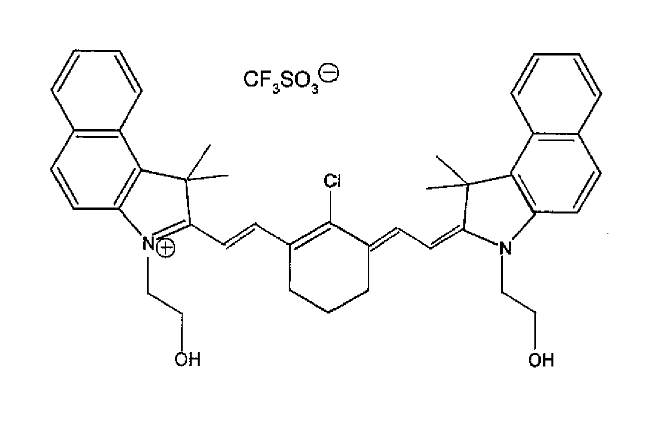

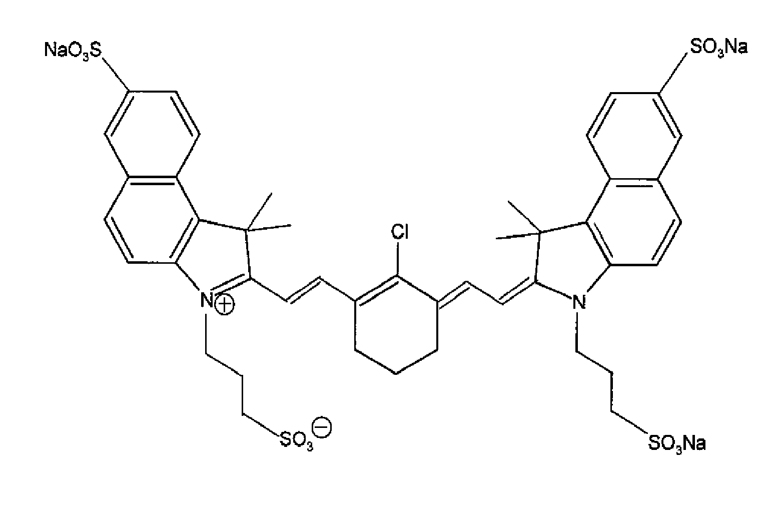

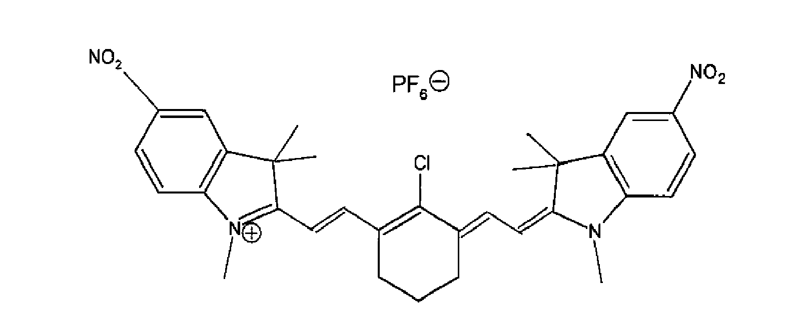

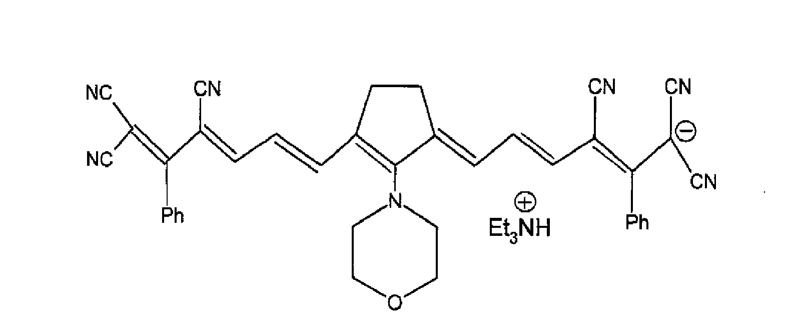

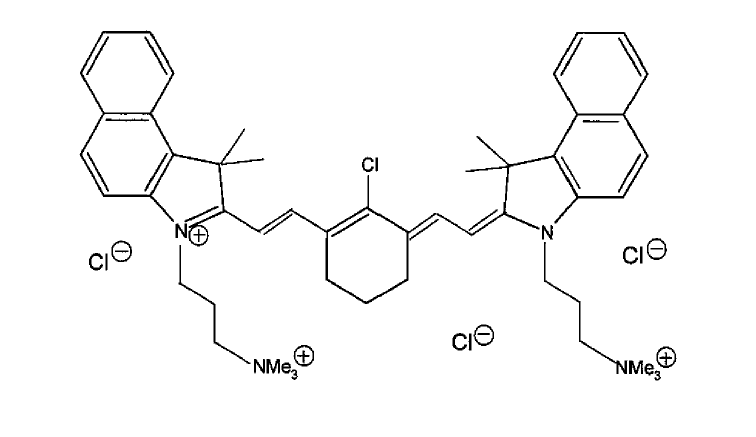

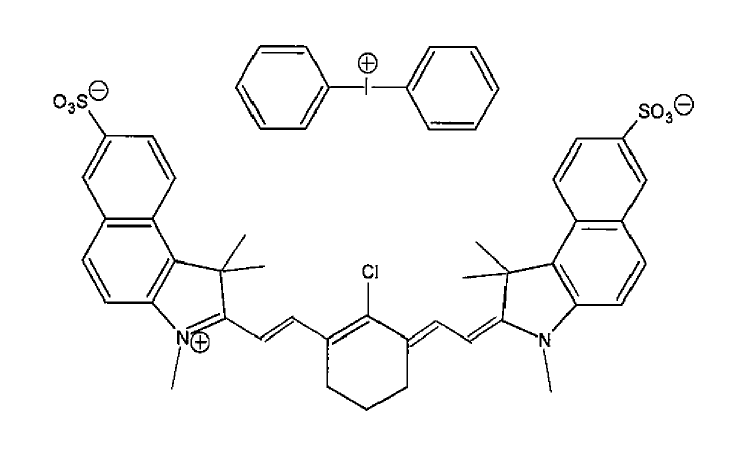

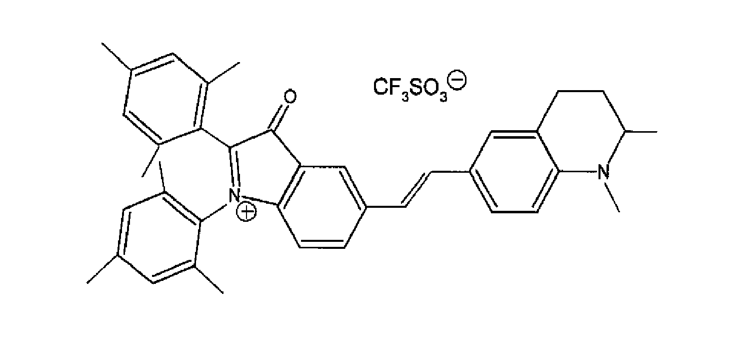

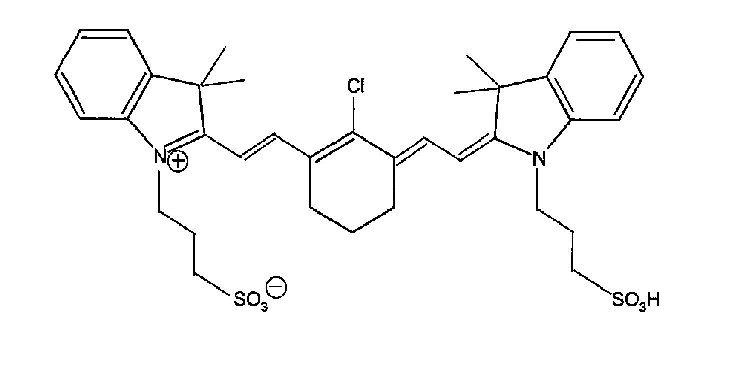

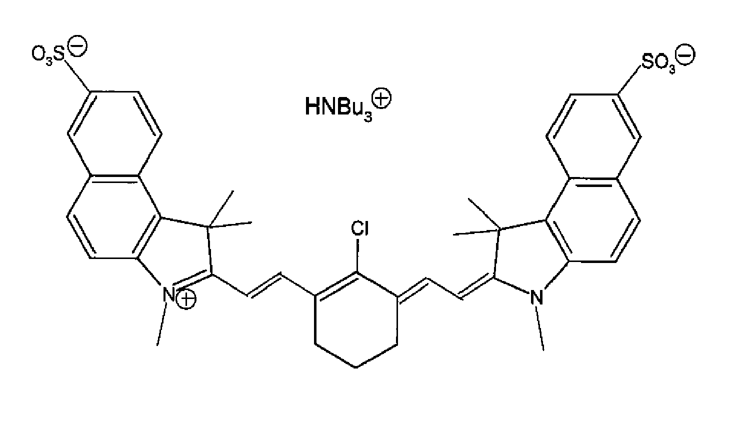

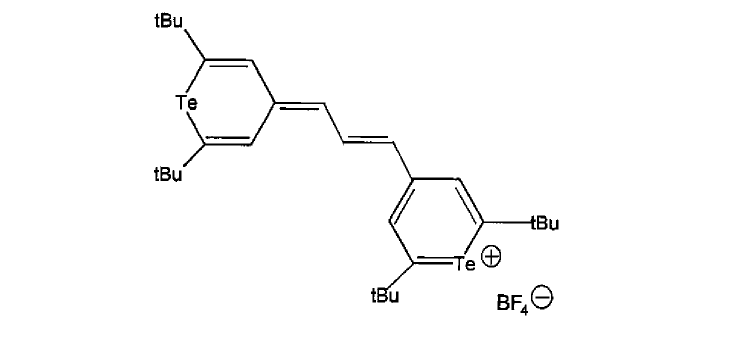

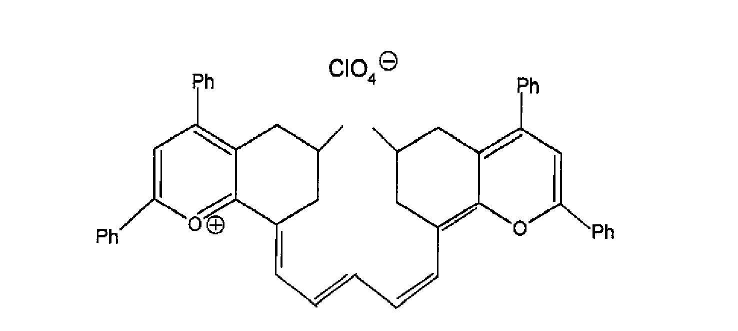

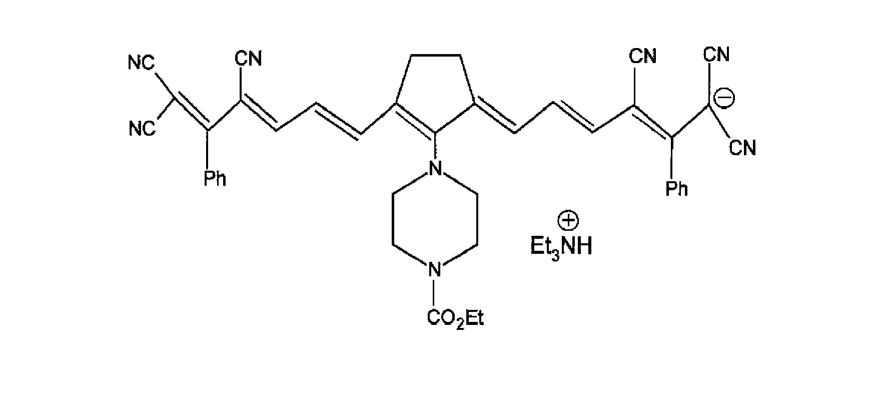

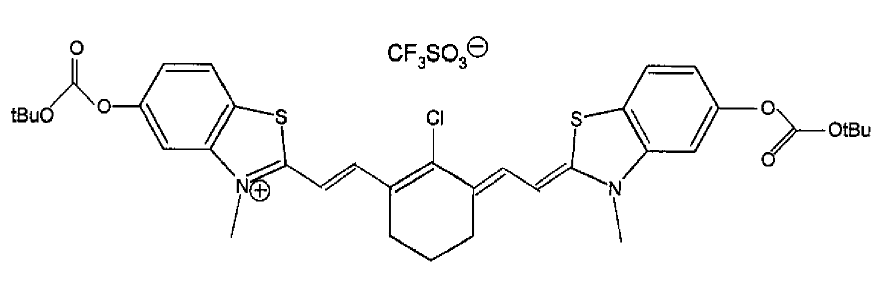

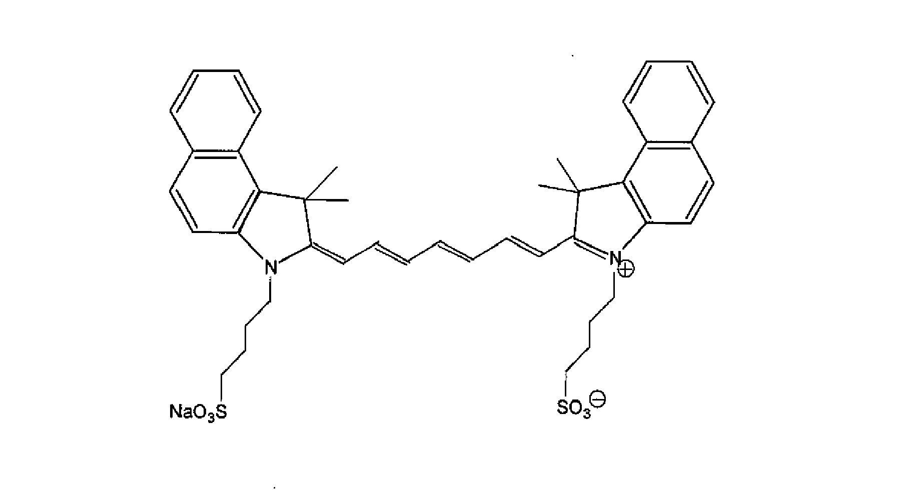

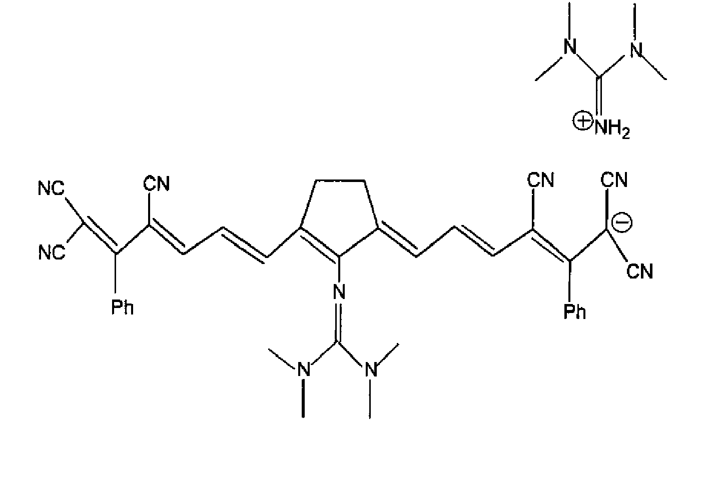

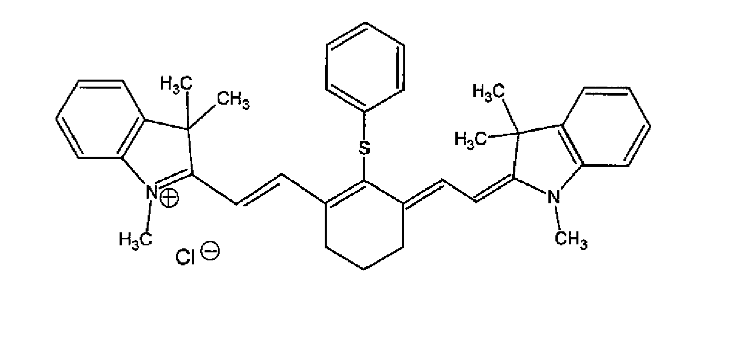

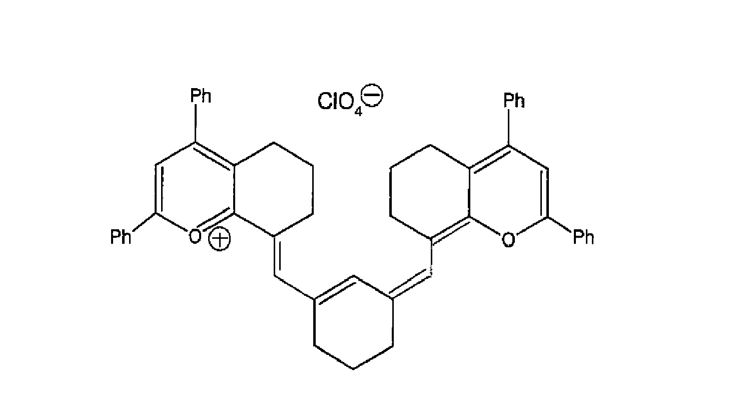

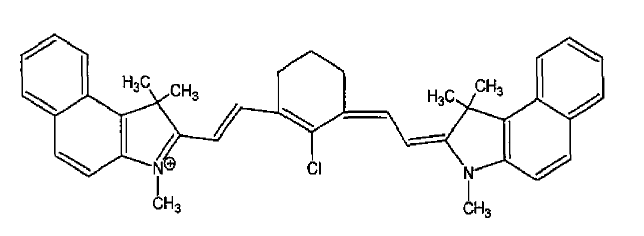

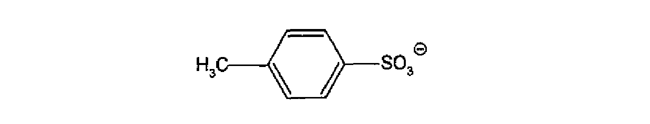

In the present invention, one sensitizer or a mixture of two or more can be used.

The sensitizers are used in combination with one or more coinitiators. Additionally, photoinitiators can be used; however, this is not preferred.

The amount of sensitizer(s) is not particularly restricted; however, if sensitizers are present, it is preferably in the range of 0.2 to 15 wt-%, based on the dry layer weight, especially preferred 0.5 to 10 wt-%. If both photoinitiators and sensitizers are present in the coating, their total amount is preferably 0.5 to 30 wt-%, based on the dry layer weight, especially preferred 1 to 15 wt-%.

A coinitiator as referred to in the present invention is a compound that is essentially unable to absorb when irradiated but forms free radicals together with the radiation-absorbing sensitizers used in the present invention. The coinitiators are for example selected from onium compounds, for example those where the onium cation is selected from iodonium (such as e.g. triaryliodonium salts), sulfonium (such as triarylsulfonium salts), phosphonium, oxylsulfoxonium, oxysulfonium, sulfoxonium, ammonium, diazonium, selenonium, arsenonium and N-substituted N-heterocyclic onium cations wherein N is substituted with an optionally substituted alkyl, alkenyl, alkinyl or aryl; N-arylglycines and derivatives thereof (e.g. N-phenylglycine); aromatic sulfonyl halides; trihalomethylarylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof and other coinitiators described in US-A-5,629,354); hexaarylbiimidazoles; thiol compounds (e.g. mercaptobenzthiazole, mercaptobenzimidazole and mercaptotriazole); 1,3,5-triazine derivatives with 1 to 3 CX₃ groups (wherein every X is independently selected from a chlorine or bromine atom, and is preferably a chlorine atom), such as e.g. 2-phenyl-4,6-bis(trichloromethyl)-s-triazine, 2,4,6-tris(trichloromethyl)-s-triazine, 2-methyl-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloromethyl)-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; oxime ethers and oxime esters, such as for example those derived from benzoin; metallocenes (preferably titanocenes, and especially preferred those with two five-membered cyclodienyl groups, such as e.g. cyclopentadienyl groups and one or two six-membered aromatic groups with at least one ortho fluorine atom and optionally also a pyrryl group, such as bis(cyclopentadienyl)-bis-[2,6-difluoro-3-(pyrr-1-yl)-phenyl]titanium and dicyclopentadiene-bis-2,4,6-trifluorophenyl-titanium or zirconium); acylphosphine oxides, diacylphosphine oxides and peroxides (e.g. those listed in EP-A1-1 03S 435 as activators of the type of an organic peroxide), α-hydroxy or α-amino acetophenones, acylphosphines, acylphosphinesulfides, carbonyl compounds such as aromatic ketones or quinones, e.g. benzophenone derivatives, Michler's ketone, thioxanthone derivatives, anthraquinone derivatives and fluorenone derivatives.

Suitable 2,2',4,4',5,5'-hexaarylbiimidazoles (in the following simply referred to as hexaarylbiimidazoles) are represented by the following formula (X): 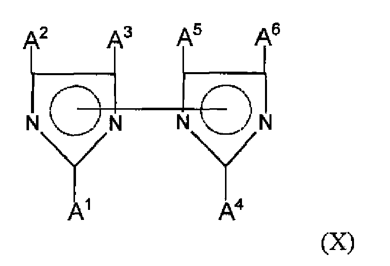 wherein A¹-A⁶ are substituted or unsubstituted C₅-C₂₀ aryl groups which are identical or different from each other and in whose rings one or more carbon atoms can optionally be substituted by heteroatoms selected from O, N and S. Suitable substituents for the aryl groups are those that do not inhibit the light-induced dissociation to triarylimidazolyl radicals, e.g. halogen atoms (fluorine, chlorine, bromine, iodine), -CN, C₁-C₆ alkyl (optionally with one or more substituents selected from halogen atoms, -CN and -OH), C₁-C₆ alkoxy, C₁-C₆ alkylthio, (C₁-C₆ alkyl) sulfonyl.

Preferred aryl groups are substituted and unsubstituted phenyl, biphenyl, naphthyl, pyridyl, furyl and thienyl groups. Especially preferred are substituted and unsubstituted phenyl groups, and particularly preferred are halogen-substituted phenyl groups.

Examples include:
2,2'-Bis(bromophenyl)-4,4',5,5'-tetraphenylbiimidazole,
2,2'-bis(p-carboxyphenyl)-4,4',5,5'-tetraphenylbiimidazole,
2,2'-bis(o-chlorophenyl)-4,4',5,5'-tetrakis(p-methoxyphenyl)biimidazole,
2,2'-bis(p-chlorophenyl)-4,4',5,5'-tetrakis(p-methoxyphenyl)biimidazole,
2,2 '-bis(p-cyanophenyl)-4,4'5,5'-tetrakis(p-methoxyphenyl)biimidazole,
2,2'-bis(2,4-dichlorophenyl)-4,4',5,5'-tetraphenylbiimidazole,
2,2'-bis(2,4-dimethoxyphenyl)4,4',5,5'-tetraphenylbiimidazole,
2,2'-bis(o-ethoxyphenyl)-4,4',5,5'-tetraphenylbiimidazole,
2,2'-bis(m-fluorophenyl)-4,4',5,5'-tetraphenylbiimidazole,
2,2'-bis(o-fluorophenyl)-4,4',5,5'-tetraphenylbiimidazole,
2,2'-bis(p-fluorophenyl)-4,4',5,5'-tetraphenylbiimidazole,
2,2'-bis(o-hexoxyphenyl)-4,4',5,5'-tetraphenylbiimidazole,
2,2'-bis(o-hexylphenyl)-4,4',5,5'-tetrakis(p-methoxyphenyl)biimidazole,
2,2'-bis(3,4-methylenedioxyphenyl)-4,4',5,5'-tetraphenylbiimidazole,
2,2'-bis(o-chlorophenyl)-4,4',5,5'-tetrakis(m-methoxyphenyl)biimidazole,
2,2'-bis(o-chlorophenyl)-4,4',5,5'-tetrakis[m-(betaphenoxy-ethoxyphenyl)]biimidazole,
2,2'-bis(2,6-dichlorophenyl)-4,4',5,5'-tetraphenylbiimidazole,
2,2'-bis(o-methoxyphenyl)-4,4',5,5'-tetraphenylbiimidazole,
2,2'-bis(p-methoxyphenyl)-4,4'-bis(o-methoxyphenyl)-5,5'-diphenylbiimidazole,
2,2'-bis(o-nitrophenyl)-4,4',5,5'-tetraphenylbiimidazole,
2,2'-bis(p-phenylsulfonylphenyl)-4,4',5,5'-tetraphenylbiimidazole,
2,2'-bis(p-sulfamoylphenyl)-4,4',5,5'-tetraphenylbiimidazole,
2,2'-bis(2,4,5-trimethylphenyl)-4,4',5,5'-tetraphenylbiimidazole,
2,2'-di-4-biphenylyl-4,4',5,5'-tetraphenylbiimidazole,
2,2'-di-1-naphthyl-4,4',5,5-tetrakis(p-methoxyphenyl)biimidazole,
2,2'-di-9-phenanthryl-4,4',5,5'-tetrakis(p-methoxyphenyl)biimidazole,
2,2'-diphenyl-4,4',5,5'-tetra-4-biphenylylbiimidazole,
2,2'-diphenyl-4,4',5,5'-tetra-2,4-xylylbiimidazole,
2,2'-di-3-pyridyl-4,4',5,5'-tetraphenylbiimidazole,
2,2'-di-3-thienyl-4,4',5,5'-tetraphenylbiimidazole,
2,2'-di-o-tolyl-4,4',5,5'-tetraphenylbiimidazole,
2,2'-di-p-tolyl-4,4'-di-o-tolyl-5,5'-diphenylbiimidazole,
2,2'-di-2,4-xylyl-4,4',5,5'-tetraphenylbiimidazole,
2,2',4,4',5,5'-hexakis(p-benylthiophenyl)biimidazole,
2,2',4,4',5,5'-hexa-1-naphthylbiimidazole,
2,2',4,4',5,5'-hexaphenylbiimidazole,
2,2'-bis(2-nitro-5-methoxyphenyl)-4,4',5,5'-tetraphenylbiimidazole,
2,2'-bis(o-nitrophenyl)-4,4',5,5'-tetrakis(m-methoxyphenyl)biimidazole, and
2,2'-bis(2-chloro-5-sulfophenyl)-4,4',5,5'-tetraphenylbiimidazole,
and especially preferred:
2,2'-bis(o-chlorophenyl)-4,4',5,5'-tetraphenylbiimidazole,
2,2'-bis(o-chlorophenyl)-4,4',5,5'-tetra(p-fluorophenyl)biimidazole,
2,2'-bis(o-bromophenyl)-4,4',5,5'-tetra(p-iodophenyl)biimidazole,
2,2'-bis(o-chlorophenyl)-4,4',5,5'-tetra(p-chloronaphthyl)biimidazole,
2,2'-bis(o-chlorophenyl)-4,4',5,5'-tetra(p-chlorophenyl)biimidazole,
2,2'-bis(o-bromophenyl)-4,4',5,5'-tetra(p-chloro-p-methoxyphenyl)biimidazole,
2,2'-bis(o-chlorophenyl)-4,4',5,5'-tetra(o,p-dichlorophenyl)biimidazole,
2,2'-bis(o-chlorophenyl)-4,4',5,5'-tetra(o,p-dibromophenyl)biimidazole,
2,2'-bis(o-bromophenyl)-4,4',5,5'-tetra(o,p-dichlorophenyl)biimidazole or
2,2'-bis(o,p-dichlorophenyl)-4,4',5,5',-tetra(o,p-dichlorophenyl)biimidazole;
but the invention is not restricted to these compounds.

Suitable hexaarylbiimidazoles can be prepared according to known methods (see e.g. US-A-3,445,232). A preferred process is the oxidative dimerization of corresponding triarylimidazoles with iron-(III)-hexacyanoferrate (II) in an alkali solution.

It is irrelevant for the purposes of the present invention which hexaarylbiimidazole isomer (or mixture af isomers) is used (e.g. 1,2'-, 1,1'-, 1,4', 2,2'-, 2,4'- and 4,4'-isomer), as long as it is photodissociable and provides triarylimidazolyl free radicals in the process.

The trihalogenmethyl compounds suitable as coinitiators are capable of forming free radicals. Trihalogenmethyl-substituted triazines and trihalogenmethyl-arylsulfones are preferred. The following can be mentioned as examples (without restricting the invention to these compounds):
2-(4-Methoxyphenyl)-4,6-bis(trichloromethyl)-s-triazine,
2-(4-chlorophenyl)-4,6-bis-(trichloromethyl)-s-triazine,
2-phenyl-4,6-bis(trichloromethyl)-s-triazine,
2,4,6-tris-(trichloromethyl)-s-triazine,
2,4,6-tris-(tribromomethyl)-s-triazine and
tribromomethylphenylsulfone.

Another type of useful coinitiators (especially for negative working IR sensitive precursors) are diaryliodonium borate compounds, represented by the following Structure (XI): 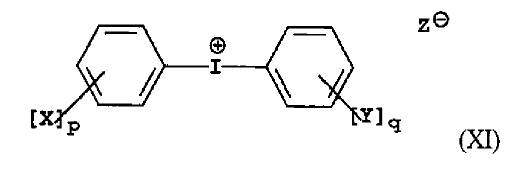 wherein X and Y are independently halo groups (for example, fluoro, chloro, or bromo), substituted or unsubstituted alkyl groups having 1 to 20 carbon atoms (for example, methyl, chloromethyl, ethyl, 2-methoxyethyl, *n*-propyl, isopropyl, *iso*butyl, *n*-butyl, *t*-butyl, all branched and linear pentyl groups, 1-ethylpentyl, 4-methylpentyl, all hexyl isomers, all octyl isomers, benzyl, 4-methoxybenzyl, *p*-methylbenzyl, all dodecyl isomers, all icosyl isomers, and substituted or unsubstituted mono-and poly-, branched and linear haloalkyls), substituted or unsubstituted alkyloxy having 1 to 20 carbon atoms (for example, substituted or unsubstituted methoxy, ethoxy, iso-propoxy, t-butoxy, (2-hydroxytetradecyl)oxy, and various other linear and branched alkyleneoxyalkoxy groups), substituted or unsubstituted aryl groups having 6 or 10 carbon atoms in the carbocyclic aromatic ring (such as substituted or unsubstituted phenyl and naphthyl groups including mono- and polyhalophenyl and naphthyl groups), or substituted or unsubstituted cycloalkyl groups having 3 to 8 carbon atoms in the ring structure (for example, substituted or unsubstituted cyclopropyl, cyclopentyl, cyclohexyl, 4-methylcyclohexyl, and cyclooctyl groups). For example, X and Y are independently substituted or unsubstituted alkyl groups having 1 to 8 carbon atoms, alkyloxy groups having 1 to 8 carbon atoms, or cycloalkyl groups having 5 or 6 carbon atoms in the ring, and more preferably, X and Y are independently substituted or unsubstituted alkyl groups having 3 to 6 carbon atoms (and particularly branched alkyl groups having 3 to 6 carbon atoms). Thus, X and Y can be the same or different groups, the various X groups can be the same or different groups, and the various Y groups can be the same or different groups. Both "symmetric" and "asymmetric" diaryliodonium borate compounds are contemplated by this invention but the "symmetric" compounds are useful (that is, they have the same groups on both phenyl rings).

In addition, two or more adjacent X or Y groups can be combined to form a fused carbocyclic or heterocyclic ring with the respective phenyl groups.

The X and Y groups can be in any position on the phenyl rings but preferably they are at the 2-or 4-positions, and more preferably at the 4-position, on either or both phenyl rings.

Despite what type of X and Y groups are present in the iodonium cation, the sum of the carbon atoms in the X and Y substituents is from about 6, and preferably from about 8, to about 40. Thus, in some compounds, one or more X groups can comprise from about 6 carbon atoms, and Y does not exist (q is 0). Alternatively, one or more Y groups can comprise from about 6 carbon atoms, and X does not exist (p is 0). Moreover, one or more X groups can comprise less than 6 carbon atoms and one or more Y groups can comprise less than 6 carbon atoms as long as the sum of the carbon atoms in both X and Y is from about 6. Still again, there may be a total of from about 6 carbon atoms on both phenyl rings.

In Structure (XI), p and q are independently 0 or integers of 1 to 5, provided that either p or q is from about 1. For example, both p and q can be 1. Thus, it is understood that the carbon atoms in the phenyl rings that are not substituted by X or Y groups have a hydrogen atom at those ring positions.

Z⁻ is an organic borate anion represented by the following Structure (XIa): 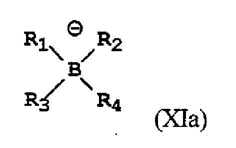 wherein R₁, R₂, R₃, and R₄ are independently substituted or unsubstituted alkyl groups having 1 to 12 carbon atoms (such as methyl, ethyl, n-propyl, iso-propyl, n-butyl, isobutyl, t-butyl, all pentyl isomers, 2-methylpentyl, all hexyl isomers, 2-ethylhexyl, all octyl isomers, 2,4,4-trimethylpentyl, all nonyl isomers, all decyl isomers, all undecyl isomers, all dodecyl isomers, methoxymethyl, and benzyl) other than fluoroalkyl groups, substituted or unsubstituted carbocyclic aryl groups having 6 to 10 carbon atoms in the aromatic ring (such as phenyl, *p-*methylphenyl, 2,4-methoxyphenyl, naphthyl, and pentafluorophenyl groups), substituted or unsubstituted alkenyl groups having 2 to 12 carbon atoms (such as ethenyl, 2-methylethenyl, allyl, vinylbenzyl, acryloyl, and crotonotyl groups), substituted or unsubstituted alkynyl groups having 2 to 12 carbon atoms (such as ethynyl, 2-methylethynyl, and 2,3-propynyl groups), substituted or unsubstituted cycloalkyl groups having 3 to 8 carbon atoms in the ring structure (such as cyclopropyl, cyclopentyl, cyclohexyl, 4-methylcyclohexyl, and cyclooctyl groups), or substituted or unsubstituted heterocyclyl groups having 5 to 10 carbon, oxygen, sulfur, and nitrogen atoms (including both aromatic and non-aromatic groups, such as substituted or unsubstituted pyridyl, pyrimidyl, furanyl, pyrrolyl, imidazolyl, triazolyl, tetrazoylyl, indolyl, quinolinyl, oxadiazolyl, and benzoxazolyl groups). Alternatively, two or more of R₁, R₂, R₃, and R₄ can be joined together to form a heterocyclic ring with the boron atom, such rings having up to 7 carbon, nitrogen, oxygen, or nitrogen atoms.

For example, R₁, R₂, R₃, and R₄ are independently substituted or unsubstituted alkyl or aryl groups as defined above, or at least 3 of R₁, R₂, R₃, and R₄ are the same or different substituted or unsubstituted aryl groups (such as substituted or unsubstituted phenyl groups). In some embodiments, all of R₁, R₂, R₃, and R₄ are the same or different substituted or unsubstituted aryl groups or, all of the groups are the same substituted or unsubstituted phenyl group. For example, Z⁻ is a tetraphenyl borate wherein the phenyl groups are substituted or unsubstituted.

Representative useful iodonium borate compounds include but are not limited to, 4-octyloxyphenyl phenyliodonium tetraphenylborate, [4-[(2-hydroxytetradecyl)-oxy]phenyl]phenyliodonium tetraphenylborate, *bis*(4-*t*-butylphenyl)iodonium tetraphenylborate, 4-methylphenyl-4'-hexylphenyliodonium tetraphenylborate, 4-methylphenyl-4'-cyclohexylphenyliodonium tetraphenylborate, bis(*t*-butylphenyl)iodonium tetrakis(pentafluorophenyl)borate, 4-hexylphenyl-phenyliodonium tetraphenylborate, 4-methylphenyl-4'-cyclohexylphenyliodonium *n*-butyltriphenylborate, 4-cyclohexylphenyl-phenyliodonium tetraphenylborate, 2-methyl-4-*t*-butylphenyl-4'-methylphenyliodonium tetraphenylborate, 4-methylphenyl-4'-pentylphenyliodonium tetrakis[3,5-bis(trifluoromethyl)phenyl]-borate, 4-methoxyphenyl-4'-cyclohexylphenyliodonium tetrakis(penta-fluorophenyl)borate, 4-methylphenyl-4'-dodecylphenyliodonium tetrakis(4-fluorophenyl)borate, bis(dodecylphenyl)iodonium tetrakis(pentafluorophenyl)-borate, and bis(4-*t*-butylphenyl)iodonium tetrakis(1-imidazolyl)borate. Useful compounds include bis(4-*t*-butylphenyl)iodonium tetraphenylborate, 4-methylphenyl-4'-hexylphenyliodonium tetraphenylborate, 2-methyl-4-*t*-butylphenyl-4'-methylphenyliodonium tetraphenylborate, and 4-methylphenyl-4'-cyclohexylphenyliodonium tetraphenylborate. Mixtures of two or more of these compounds can also be used.

Many coinitiators can also function as photoinitiators when they are exposed in their absorption band. This way, photosensitive layers can be obtained that are e.g. sensitive over a wide spectral range because a photoinitiator or sensitizer covers the long-wavelength spectral range (IR and/or visible range) and a coinitiator covers the short-wavelength spectral range (e.g. the UV range). This effect can be advantageous if the consumer wants to irradiate the same material with different radiation sources. In this case, the coinitiator functions as an actual coinitiator in the sense of the definition given above for the IR or visible range, while it functions as a photoinitiator for the UV range.

In the present invention, one coinitiator or a mixture of coinitiators can be used.

The amount of coinitiator(s) is not particularly restricted; however, it is preferably in the range of 0.2 to 25 wt-%, based on the dry layer weight, especially preferred 0.5 to 15 wt-%.

Further examples of suitable sensitizers and coinitiators for IR-sensitive coatings are also mentioned in WO 2004/041544, WO 2000/48836 and DE 10 2004 003143.

### Free-radical polymerizable component

All monomers, oligomers and polymers which comprise at least one C-C double bond can be used as free-radical polymerizable monomers, oligomers and polymers. Monomers/oligomers/polymers with C-C triple bonds can also be used, but they are not preferred. Suitable compounds are well known to the person skilled in the art and can be used in the present invention without any particular limitations. Esters of acrylic and methacrylic acids, itaconic acid, crotonic and isocrotonic acid, maleic acid and fumaric acid with one or more unsaturated groups in the form of monomers, oligomers or prepolymers are preferred. They may be present in solid or liquid form, with solid and highly viscous forms being preferred. Compounds suitable as monomers include for instance trimethylol propane triacrylate and trimethacrylate, pentaerythritol triacrylate and trimethacrylate, dipentaerythritolmonohydroxy pentaacrylate and pentamethacrylate, dipentaerythritol hexaacrylate and hexamethacrylate, pentaerythritol tetraacrylate and tetramethacrylate, ditrimethylol propane tetraacrylate and tetramethacrylate, diethyleneglycol diacrylate and dimethacrylate, triethyleneglycol diacrylate and dimethacrylate or tetraethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins.

In addition to monomers and/or oligomers, use can also be made of polymers comprising free-radical polymerizable C-C double bonds in the main or side chains. Examples thereof include reaction products of maleic acid anhydride copolymers and hydroxyalkyl(meth)acrylates (cf. e.g. DE 4 311 738 C1); (meth)acrylic acid polymers, partially or fully esterified with allyl alcohol (cf. e.g. DE 3 332 640 A1); reaction products of polymeric polyalcohols and isocyanatoalkyl(meth)acrylates; unsaturated polyesters; (meth)acrylate-terminated polystyrenes, poly(meth)acrylic acid ester, poly(meth)acrylic acids, poly(meth)acrylamides; (meth)acrylic acid polymers, partially or fully esterified with epoxides comprising free-radical polymerizable groups; and polymers with allyl side-groups which can for example be obtained by polymerization of allyl(meth)acrylate, optionally with further comonomers.

Free-radical polymerizable compounds that can be used in the present invention also include the compounds disclosed in WO 2005/054952 that have a molecular weight of 3,000 or less and are reaction products obtained by reacting a diisocyanate with (i) an ethylenically unsaturated compound with one hydroxy group, and at the same time (ii) a saturated organic compound with one NH group and one OH group, wherein the reactants are used in amounts according to the following condition:

Number of moles of isocyanate groups ≤ number of moles of OH plus NH groups.

Additional suitable C-C unsaturated free-radical polymerizable compounds are described e.g. in EP 1 176 007 A2.

It is of course possible to use different kinds of monomers, oligomers or polymers in admixture; furthermore, mixtures of monomers and oligomers and/or polymers can be used in the present invention, as well as mixtures of oligomers and polymers.

The free-radical polymerizable component is preferably used in an amount of 5 to 95 wt-%, based on the dry layer weight, especially preferred 10 to 85 wt-%.

### Benders

Suitable binders are polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331).

Further suitable binders are "reactive binders", i.e. polymeric binders having side chains comprising free radical polymerizable groups. For example the reactive side groups are selected from acryl, methacryl, styryl, allyl, and mixtures of two or more thereof. The polymer backbone is not limited and is for example selected from an acrylic backbone, methacrylic backbone, acetal backbone, urethane backbone, and styrene backbone; copolymers of the aforementioned are also possible. Suitable reactive binders are disclosed in a number of patent applications e.g. WO 2004/014652 A1, WO 89/06659 A1, DE 29 03 270 A1, WO 95/12147, EP 410 242, and US 4,035,321.

The total amount of binders is preferably 5 to 95 wt-%, based on the dry layer weight, especially preferred 10 to 85 wt-%.

### NEGATIVE DIAZO-SYSTEMS (UV-SENSITIVE)

Another type of negative working UV-sensitive coating - applied onto a substrate - comprises a diazonium polycondensation product.

Diazonium polycondensation products known to the person skilled in the art can be used as diazonium polycondensation product. Such condensation products can for example be prepared according to known methods by condensing a diazo monomer described in EP-A-0 104 863 with a condensation agent such as formaldehyde, acetaldehyde, propionaldehyde, butyraldehyde, isobutyraldehyde or benzaldehyde. Furthermore, co-condensation products are used which in addition to the diazonium salt units also comprise other units which are not photosensitive and are derived from condensable compounds, in particular aromatic amines, phenols, phenol ethers, aromatic thiolethers, aromatic hydrocarbons, aromatic heterocycles and organic acid amides. Especially advantageous examples of the diazonium polycondensation products include reaction products of diphenylamine-4-diazonium salts, which optionally contain a methoxy group in the phenyl group carrying the diazo group, and formaldehyde or 4,4'-bismethoxymethyldiphenylether. Aromatic sulfonates such as 4-tolylsulfonate or mesitylene sulfonate, tetrafluoroborate, hexafluorophosphate, hexafluoroantimonate and hexafluoroarsenate are especially suitable as anions of these diazo resins. The diazonium polycondensation product is preferably present in an amount of 3 to 60 wt-% in the photosensitive composition.

Hybrid systems of diazonium polycondensation products and the above-mentioned UV-sensitive free-radical polymerizable system can also be used in the negative working radiation-sensitive coating.
Suitable binders for such systems are polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 5 to 95 wt%, based on the dry layer weight, especially preferred 10 to 85 wt-%.

### SINGLE-LAYER NEGATIVE WORKING IR-SENSITIVE ELEMENTS

Another type of negative working single-layer IR-sensitive elements are elements wherein the radiation-sensitive layer on a substrate is rendered insoluble in or impenetrable by aqueous alkaline developer upon IR irradiation and comprises
(i) at least one compound which forms an acid upon the application of heat (in the following also referred to as "latent Bronsted acid"), and
(ii) a component cross-linkable by an acid (in the following also referred to as "cross-linking agent") or a mixture thereof and
(iii) at least one IR absorber.
Systems based on this principle are for example described in EP 0 625 728 B1 and EP 0 938 413 B1.

All the sensitizers described above which absorb radiation from the IR range (more than 750 to 1,200 nm) can be used as IR absorbers.

Ionic and nonionic Bronsted acids can be used as latent Bronsted acid. Examples of ionic latent Bronsted acids include onium salts, in particular iodonium, sulfonium, oxysulfoxonium, oxysulfonium, phosphonium, selenonium, telluronium, diazonium and arsonium salts. Specific examples are diphenyliodonium-hexafluorophosphate, triphenylsulfonium-hexafluoroantimonate, phenylmethyl-ortho-cyanobenzylsulfonium-tri-fluoromethanesulfonate and 2-methoxy-4-aminophenyl-diazonium-hexafluorophosphate.

Examples of nonionic latent Bronsted acids include RCH₂X, RCHX₂, RCX₃, R(CH₂X)₂ and R(CH₂X)₃, wherein X represents Cl, Br, F or CF₃SO₃ and R is an aromatic, aliphatic or araliphatic group.

Ionic latent Bronsted acids of the formula

X^{⊕}R^{1a}R^{1b}R^{1c}R^{1d} W^{⊝}

are also suitable, wherein if X represents iodine, R^{1c} and R^{1d} are free electron pairs and R^{1a} and R^{1b} are aryl groups or substituted aryl groups,
if X represents S or Se, R^{1d} is a free electron pair and R^{1a}, R^{1b}, R^{1c} are independently selected from aryl groups, substituted aryl groups, an aliphatic group or substituted aliphatic group,
if X represents P or As, R^{1d} can be an aryl group, substituted aryl group, aliphatic group or substituted aliphatic group, and
wherein W^{⊝} is selected from BF₄^{⊝}, CF₃SO₃^{⊝}, SbF₆^{⊝}, CCl₃CO₂^{⊝}, ClO₄^{⊝}, AsF₆^{⊝} or PF₆^{⊝}.

C₁-C₅-alkyl sulfonates, arylsulfonates (e.g. benzoin tosylate, 2-hydroxymethylbenzoin tosylate and 2,6-dinitrobenzyl tosylate) and N-C₁-C₅-alkyl-sulfonylsulfonamides (e.g. N-methanesulfonyl-p-toluene-sulfonamide and N-methanesulfonyl-2,4-dimethylbenzenesulfonamide) are also suitable.

Specific suitable onium compounds are for example listed in detail in US 5,965,319 as formulas (I) to (III).

The latent Bronsted acids are preferably used in an amount of 0.5 to 50 wt-%, especially preferred 3 to 20 wt-%, based on the dry layer weight.

The cross-linking agent can for example be a resin, selected from resols, C₁-C₅-alkoxy-methylmelamines, C₁-C₅-alkoxymethyl-glycoluril resins, poly(C₁-C₅-alkoxy-methylstyrenes) and poly(C₁-C₅-alkoxymethylacrylamides), epoxidized novolak resins and urea resins. In particular, compounds comprising at least 2 groups in a molecule, selected from hydroxymethyl, alkoxymethyl, epoxy and vinylether groups, bonded to an aromatic ring, can be used as cross-linking agents; of those, phenol derivatives with at least 2 groups selected from hydroxymethyl and alkoxymethyl groups, bonded to a benzene ring, 3 to 5 benzene rings and a molecular weight of 1,200 or less, as listed in columns 31 to 37 of US 5,965,319, are preferred.

The cross-linking agent is preferably used in an amount of 5 to 90 wt-%, based on the dry layer weight, especially preferred 10 to 60 wt-%.

The radiation-sensitive layers of this type can contain binders, for example selected from alkali-soluble or dispersible (co)polymers, such as novolaks, acetone pyrogallol resin, polyhydroxystyrenes and hydroxystyrene-N-substituted maleimide-copolymers as listed in US 5,965,319 as component (C), polymers as mentioned in US 5,919,601 as binder resins and copolymers as described in DE 199 36 331.

Preferably binders are present in an amount of 5 to 95 wt-%, based on the dry layer weight, especially preferred 5 to 60 wt-%.

In principle, known IR-sensitive elements with a single-layer structure, as for example described in US 5,919,501 and WO 00/17711 A1, can be processed according to the present invention.

### Positive working radiation-sensitive elements,

### UV-SENSITIVE

Positive working UV-sensitive elements can for example be based on quinone diazides (preferably naphthoquinone diazides) and novolaks, as for example described in US 4,594,306.

Suitable binders for such coatings are for instance polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 5 to 95 wt-%, based on the dry layer weight, especially preferred 10 to 85 wt-%.

### IR-SEMSOTOVE

There are numerous examples of positive working IR-sensitive elements, which can be divided into two groups: those with a radiation-sensitive coating comprising only one layer and those where the radiation-sensitive coating comprises at least two layers.

### Single-layer plates

Usually, single-layer positive working IR-sensitive elements comprise
(a) an optionally pretreated substrate
(b) a positive working heat-sensitive layer comprising
   (i) at least one polymer soluble in aqueous alkaline developer, such as e.g. a novolak resin,
   (ii) at least one component which reduces the aqueous alkaline developer solubility of the developer soluble polymer (e.g. novolak), wherein said reduction in solubility is reversed upon the application of heat ("insolubilizer"), and
   (iii) optionally an IR absorber (i.e. a compound which absorbs IR radiation and converts it to heat),
wherein components (i) and (ii) do not have to be present as separate substances but can be used in the form of an accordingly functionalized novolak. It is also possible to use an IR absorber that also acts as insolubilizer. Such single-layer IR-sensitive positive working elements are for example described in EP 825 927 B1.

Polymers with hydroxyl, carboxylic acid, amino, amide and maleimide groups can for example be used as polymers soluble in aqueous alkaline developer. In particular, these compounds include phenolic resins, copolymers of 4-hydroxystyrene and 3-Methyl-4-hydroxystyrene or 4-methoxystyrene, copolymers of (meth)acrylic acid and styrene, copolymers of maleimides and styrene, hydroxy- or carboxy-functionalized celluloses, copolymers of maleic acid anhydride and styrene and partially hydrolyzed polymers of maleic acid anhydride. Phenolic acids, in particular novolak, are especially preferred.

Suitable novolak resins are condensation products of phenols, e.g. phenol itself, C-alkyl-substituted phenols (including cresols, xylenols, p-tert-butylphenol, p-phenylphenol and nonyl phenols) and diphenols (e.g. bisphenol-A), with suitable aldehydes such as formaldehyde, acetaldehyde, propionaldehyde, and furfuraldehyde. The type of catalyst and the molar ratio of the reactants determine the molecular structure and thus the physical properties of the resin. An aldehyde/phenol ratio of about 0.5:1 to 1:1, preferably 0.5:1 to 0.8:1, and an acid catalyst are used in order to produce those phenolic resins known as "novolaks" and having a thermoplastic character. However, as used in the present application, the term "novolak resin" should also encompass the phenolic resins known as "resols" which are obtained at higher aldehyde/phenol ratios and in the presence of alkaline catalysts.

Based on the dry layer weight, the novolaks resin is preferably present in an amount of at least 40 wt-%, more preferred at least 50 wt-%, even more preferred at least 70 wt-% and particularly preferred at least 80 wt-%. Usually, the amount does not exceed 95 wt-%, more preferred 85 wt-%.

The chemical structure of the IR absorber is not particularly restricted as long as it is capable of converting the absorbed radiation into heat. The IR absorbers mentioned above in connection with photopolymerizable IR-sensitive elements can be used. The IR absorber is preferably present in an amount of at least 0.1 wt-% based on the dry layer weight, more preferred at least 1 wt-%, and particularly preferred at least 2 wt-%. Usually, the amount of IR absorber does not exceed 25 wt-%, more preferred 20 wt-% and particularly preferred 15 wt-%. Either a single IR absorber or a mixture of two or more can be present; in the latter case, the amounts given refer to the total amount of all IR absorbers.

The amount of IR absorber to be used also has to be considered in view of the dry layer thickness of the coating. It should preferably be selected such that the optical density of the coating - measured for example on a transparent polyester film - preferably shows values between 0.4 and 1.0 at the wavelength of the IR light with which the coating is irradiated.

The IR-sensitive coating furthermore comprises at least one substance that reduces the aqueous alkaline developer solubility of the polymer like novolak, whereby this reduction in solubility is reversed by the application of heat. In the following, this substance is briefly referred to as "insolubilizer". The insolubilizer may or may not be covalently bonded to a polymer.

Use can be made of insolubilizers already described in the prior art or of different ones. Suitable insolubilizers include for example the compounds described in WO 98/42507 and EP-A 0 823 327 which are not photosensitive and comprise functional groups that can enter into a hydrogen bond with the phenolic OH groups of novolak resins. WO 98/42507 mentions sulfone, sulfoxide, thion, phosphinoxide, nitrile, imide, amide, thiol, ether, alcohol, urea, nitroso, azo, azoxy and nitro groups, halogens and in particular keto groups as suitable functional groups. Xanthone, flavanone, flavone, 2,3-diphenyl-1-indenone, pyrone, thiopyrone and 1'-(2'-acetonaphthonyl)benzoate are mentioned as examples of suitable compounds.

In WO 99/01795, polymers with specific functional groups Q which preferably do not comprise diazide groups, acid groups or acid-forming groups are used as insolubilizers, and according to a preferred embodiment, Q is selected from amino, monoalkylamino, dialkylamino, amido, monoalkylamido, dialkylamido groups, fluorine atoms, chlorine atoms, carbonyl, sulfinyl or sulfonyl groups. These polymeric insolubilizers can also be used in the present invention.

The insolubilizers described in WO 99/01796, in this case compounds with diazide units, can be used in the present invention as well.

Another group of insolubilizers suitable for use in the present invention is described in WO 97/39894. They are e.g. nitrogen-containing compounds wherein at least one nitrogen atom is quatemized and forms part of a heterocyclic ring; examples include e.g. quinolinium compounds, benzothiazolium compounds and pyridinium compounds, and in particular cationic trimethylmethane dyes such as Victoria Blue (C I Basic Blue 7), crystal violet (C I Basic Violet 3) and ethyl violet (C I Basic Violet 4). Furthermore, compounds with carbonyl function such as N-(4-bromobutyl)-phthalimide, benzophenone and phenanthrenequinone are mentioned. Compounds of the formula Q₁-S(O)ₙ-Q₂ (wherein Q₁ = optionally substituted phenyl or alkyl group; n = 0, 1 or 2; Q₂ = halogen atom or alkoxy group), Acridine Orange Base and ferrocenium compounds can be used as well.

If the IR absorbers comprise the structural elements mentioned in WO 97/39894, they also function as insolubilizers.

The functionalized novolaks described in US 6,320,018 B can be used in the heat-sensitive elements of the present invention as well. These novolaks contain substituents which allow a two- or four-center hydrogen bond (preferably a four-center hydrogen bond, also named quadrupol hydrogen bonding QHB) between the polymer molecules. This also decreases the aqueous alkaline developer solubility of the underlying novolak. Such hydrogen bonds are broken by heating and the original solubility of the novolak is restored. If such a functionalized novolak is used, it assumes the function of components (i) and (ii) of the heat-sensitive composition so that the additional use of a novolak without corresponding functional groups and/or an insolubilizer as described above is not necessary, but not excluded, either.

The functionalized novolaks comprise at least one covalently bonded unit and at least one non-covalently bonded unit, with the non-covalent bond being thermally unstable; these novolaks have a two- or four-center hydrogen bond at essentially every non-covalently bonded unit. A preferred group of such functionalized novolaks which can be used as novolak with a simultaneous insolubilizing function can be described with the following formula (XIV): 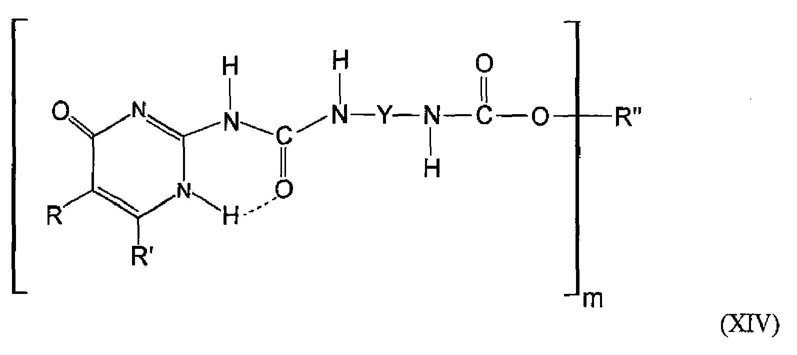 wherein R and R' are independently selected from a hydrogen atom and a cyclic or straight or branched saturated or unsaturated hydrocarbon group with preferably 1 to 22 carbon atoms (preferably hydrogen and C₁-C₄ alkyl), R" is a phenolic group derived from a novolak R"(OH)ₚ, Y is a divalent cyclic or straight or branched saturated or unsaturated hydrocarbon group with preferably 1 to 22 carbon atoms derived from a diisocyanate of the formula Y(NCO)₂ (e.g. isophorone diisocyanate, toluene-1,2-diisocyanate, 3-isocyanatomethyl-1-methylcyclo-hexylisocyanate), m is at least 1 and p is 1 or 2.

The preparation of functionalized novolaks of formula (XIV) can e.g. be inferred from US 2002/0,150,833 A1.

Another class of suitable functionalized resins, such as e.g. functionalized phenolic resins and in particular functionalized novolaks, is disclosed in US 6,537,735 B. While the non-functionalized resin is soluble in aqueous alkaline developer, the functionalized resin is insoluble in the developer; however, the application of heat (for example generated by IR radiation) renders it soluble in the developer. Preferably, the non-functionalized resin comprises OH or SH groups which in the functionalized resin are at least partially converted to covalently bonded functional groups Q; preferably, the functional groups Q are formed via an esterification reaction of the OH groups and are preferably selected from -O-SO₂-tolyl, - O-dansyl, -O-SO₂-thienyl, -O-SO₂-naphthyl and -O-CO-phenyl. The ratio of functional groups Q to OH groups is preferably 1:100 to 1:2, more preferred 1:50 to 1:3. The novolak resins, resols, acrylic resins with phenolic side chains and hydroxystyrenes described above can for example be used as non-functionalized resins. An especially preferred functionalized resin of this class is a phenolic resin (preferably a novolak), partially (e.g. 10 to 20%) esterified with toluenesulfonic acid or sulfonic acid chloride; however, all the other functionalized resins described in US 6,537,735 can be used in the present invention as well.

Although all the insolubilizers mentioned above can be used in the heat-sensitive coating of the present invention, the following are preferred: Cyanine dyes, triarylmethane dyes, quinolinium compounds, the above insolubilizers with (a) keto group(s) and the above insolubilizers with (a) sulfone group(s), as well as novolaks functionalized with substituents capable of forming four-center hydrogen bonds. The cyanine dyes, triarylmethane dyes, quinolinium compounds, ketones and sulfones can be used as low-molecular substances or bonded to a polymer.

A single insolubilizer or mixtures of two or more compounds can be used in the heat-sensitive elements of the present invention.

The amount of insolubilizer(s) is not particularly restricted as long as it reduces the aqueous alkaline developer solubility of the novolak. However, the solubility reduction has to take place to such an extent that when an aqueous alkaline developer is used, the heated areas of the coating are removed considerably faster than the non-heated areas.

Independently of whether the insolubilizer also functions as IR absorber, it is preferably present in an amount of at least 0.1 wt-% based on the dry layer weight, more preferred at least 0.5 wt-%, especially preferred at least 1 wt-% and particularly preferred at least 2 wt-%. Preferably, no more than 25 wt-%, more preferred no more than 15 wt-%, are used.

Optional binders are for instance polymers/copolymers soluble or dispersible in aqueous alkaline developer, such as e.g. phenolic resins such as novolaks and resols, and copolymers of (meth)acrylic acid, N-phenylmaleimide and (meth)acrylamide (see DE 199 36 331). The total amount of binders is preferably 1 to 99 wt-%, based on the dry layer weight, especially preferred 10 to 98 wt-%.

### Dual-layer plates

IR sensitive elements useful in the present invention can also be positive working dual-layer elements wherein a inner layer (also referred to as "first layer" or "bottom layer") is provided on the hydrophilic surface of the substrate which is soluble in aqueous alkaline developer and a top layer ("masking layer") on top of the first layer.

The inner layer comprises a first polymeric binder that is removable by the developer and typically soluble in the developer to reduce sludging of the developer. In addition, the first polymeric binder is usually insoluble in the solvent used to coat the outer layer so that the outer layer can be coated over the inner layer without dissolving the inner layer. Mixtures of these first polymeric binders can be used if desired in the inner layer. This first polymeric binder can be for the inner layer include (meth)acrylonitrile polymers, (meth)acrylic resins comprising carboxy groups, polyvinyl acetals, maleated wood rosins, styrene-maleic anhydride copolymers, (meth)acrylamide polymers including polymers derived from N-alkoxyalkyl methacrylamide, polymers derived from an N-substituted cyclic imide, polymers having pendant cyclic urea groups, and combinations thereof. Still other useful polymeric binders include polymers derived from an N-substituted cyclic imide (especially N-phenylmaleimide), a (meth)acrylamide (especially methacrylamide), a monomer having a pendant cyclic urea group, and a (meth)acrylic acid (especially methacrylic acid). Polymeric binders of this type include copolymers that comprise from about 20 to about 75 mol % and typically about 35 to about 60 mol % or recurring units derived from N-phenylmaleimide, N-cyclohexyl-maleimide, N-(4-carboxyphenyl)maleimide, N-benzylmaleimide, or a mixture thereof, from about 10 to about 50 mol % of recurring units derived from acrylamide, methacrylamide, or a mixture thereof, and from about 5 to about 30 mol % of recurring units derived from methacrylic acid. Other hydrophilic monomers, such as hydroxyethyl methacrylate, may be used in place of some or all of the methacrylamide. Other alkaline soluble monomers, such as acrylic acid or 5-Methacrylamido-1,2,3,4-tetrazole, may be used in place of some or all of the methacrylic acid. Optionally, these polymers can also include recurring units derived from (meth)acrylonitrile or N-[2-(2-oxo-1-imidazolidinyl)ethyl]-methacrylamide.

Still other useful polymeric binders for the inner layer can comprise, in polymerized form, from about 5 mol % to about 30 mol % of recurring units derived from an ethylenically unsaturated polymerizable monomer having a carboxy group (such as acrylic acid, methacrylic acid, itaconic acid, and other similar monomers known in the art (acrylic acid and methacrylic acid are preferred), from about 20 mol % to about 75 mol % of recurring units derived from N-phenylmaleimide, N- cyclohexylmaleimide, or a mixture thereof, optionally, from about 5 mol % to about 50 mol % of recurring units derived from methacrylamide, and from about 3 mol % to about 50 mol % one or more recurring units derived from monomer compounds of the following Structure:

CH₂=C(R₂)-C(=O)-NH-CH₂-OR₁

wherein R₁ is a C₁ to C₁₂ alkyl, phenyl, C₁ to C₁₂ substituted phenyl, C₁ to C₁₂ aralkyl, or Si(CH₃)₃, and R₂ is hydrogen or methyl, as described for example in U.S. Patent 7,186,482 (Kitson et al.). Methods of preparation of certain of these polymeric materials are disclosed in U.S. Patent 6,475,692 (Jarek).

Additional useful polymeric binders for the inner layer are described for example, in U.S. Patents 7,144,661 (Ray et al.), US 2007/0269727 (Savariar-Hauck et al), and 7,223,506 (Kitson et al.), and U.S. Patent Application Publications 2006/0257764 (Ray et al.) and 2007/0172747 (Ray et al.).

The additional polymeric binders can comprise more than 50% and up to 100% (dry weight) of the total polymeric materials in the inner layer. Still other useful additional polymeric materials include copolymers that comprises from about 1 to about 30 mole % of recurring units derived from N-phenylmaleimide, from about 1 to about 30 mole % of recurring units derived from methacrylamide, from about 20 to about 75 mole % of recurring units derived from acrylonitrile, and from about 20 to about 75 mole % of recurring units derived from one or more monomers of the Structure (XI):

CH₂=C(R₂₃)-CO₂-CH₂CH₂-NH-CO-NH-*p*-C₆H₄-R₂₂ (XI)

wherein R₂₂ is OH, COOH, or SO₂NH₂, and R₂₃ is H or methyl, and, optionally, from about 1 to about 30 mole % from about 3 to about 20 mole % of recurring units derived from one or more monomers of the Structure (XII):

CH₂=C(R₂₅)-CO-NH-*p*-C₆H₄-R₂₄ (XII)

wherein R₂₄ is OH, COOH, or SO₂NH₂ and R₂₅ is H or methyl.

The inner layer may also comprise one or more secondary additional polymeric materials that are resins having activated methylol and/or activated alkylated methylol groups. The secondary additional polymeric materials can include, for example resole resins and their alkylated analogs, methylol melamine resins and their alkylated analogs (for example melamine-formaldehyde resins), methylol glycoluril resins and alkylated analogs (for example, glycoluril-formaldehyde resins), thiourea-formaldehyde resins, guanamine-formaldehyde resins, and benzoguanamine-formaldehyde resins. Commercially available melamine-formaldehyde resins and glycoluril-formaldehyde resins include, for example, CYMEL^{®} resins (Dyno Cyanamid) and NIKALAC^{®} resins (Sanwa Chemical). The resin having activated methylol and/or activated alkylated methylol groups is typically a resole resin or a mixture of resole resins. Resole resins are well known to those skilled in the art. They are prepared by reaction of a phenol with an aldehyde under basic conditions using an excess of phenol. Commercially available resole resins include, for example, GP649D99 resole (Georgia Pacific) and BKS-5928 resole resin (Union Carbide). Useful secondary additional polymeric materials can also include copolymers that comprise from about 25 to about 75 mole % of recurring units derived from N-phenylmaleimide, from about 10 to about 50 mole % of recurring units derived from methacrylamide, and from about 5 to about 30 mole % of recurring units derived from methacrylic acid. These secondary additional copolymers are disclosed in U.S. Patents 6,294,311 (Shimazu et al.) and 6,528,228 (Savariar-Hauck et al.). The inner layer may also comprise a polymer having pendant 1H-tetrazole groups generally present in an amount of at least 10 weight %, and generally from about 60 to 95 weight % of the total dry inner layer weight.

An IR absorber ("photothermal conversion material") is present in the first layer, or the top layer or in both layers; it can also be present in a separate "absorber layer". Preferably the IR absorber is present in the first layer.

The chemical structure of the IR absorber is not particularly restricted as long as it is capable of converting the absorbed IR radiation into heat. The IR absorbers mentioned above in connection with photopolymerizable IR-sensitive elements can be used. The IR absorber is preferably present in an amount of at least 1 wt-% based on the dry layer weight of the layer in which it is present, more preferred at least 2 wt-%, and particularly preferred at least 5 wt-%. Usually, the amount of IR absorber does not exceed 35 wt-%, more preferred 30 wt-% and particularly preferred 25 wt-% of the layer in which it is present. If the IR absorber is only present in the first layer, its amount in said layer is preferably from 10 to 20 wt-%, based on the dry layer weight of the first layer. Either a single IR absorber or a mixture of two or more can be present; in the latter case, the amounts given refer to the total amount of all IR absorbers present in one layer.

The top layer protects the first layer from being dissolved by an aqueous alkaline developer. It is therefore necessary that the top layer itself is not soluble or dispersible in or penetrable by an aqueous alkaline developer. By the wording "not soluble in, dispersible in or penetrable by an aqueous alkaline developer", it is meant that the top layer can resist the attack of an aqueous alkaline developer having a pH of at least 8 for at least 90 seconds. However, upon exposure to IR radiation the top layer becomes removable by an aqueous alkaline developer (necessary dwell time: less than 60 seconds).

Various dual-layer plates are known in the art, however, the mechanisms of change of solubility/dispersibility/penetrability due to exposure to IR radiation are still not fully understood. Such dual-layer systems are for instance described in US 6,352,812, US 6,352,811, US 6,358,669, US 2002/0,150,833 A1, US 6,320,018, US 6,537,735 and WO 02/14071.

According to one embodiment the top layer (also referred to in the following as "masking layer") may be insoluble in the aqueous alkaline developer and be made penetrable to the developer after imaging. The removed mask remains insoluble in the developer. Polymers such as nitrocellulose and polymethylmethacrylate are examples of such cases are described in US 6352812.

In another embodiment, the masking layer may show a slower rate of solubility in the developer than the first layer enabling sufficient protection of the image areas during the development stage. This is achieved by the use of polymers in the top layer with low acid numbers which enables solubility in the developer but at a slower rate than the inner layer. For this purpose top layer polymers may have pendant carboxyl, carboxy anhydride, sulfonamide, sulfonic acid, phosphonic acid, or phosphoric acid and tetrazole groups and may be obtained by reaction with suitable one or more monmers such as allyl (meth)acrylates, alkyl (meth)acrylates, hydroxyalkyl (meth)acrylates, (meth)acrylamides that can be substituted by alkyl or aryl groups, (meth)acrylates of polyethylene oxide or propylene oxide, (meth)acrylonitriles, styrene or styrene derivatives, vinyl acetate, vinyl carbazole, vinyl pyrrolidone, vinyl alcohol, N-substituted maleimides, or half esters of ring-opened maleic acid anhydrides. Other monomers from which B recurring units can be derived would be readily apparent to a skilled artisan. Polymers with pendant acid groups can also be obtained by condensation reactions such as described in US 7,241,556.

Phenolic resins are generally insoluble in low pH developers of about pH 10. However phenolic resins functionalised with carboxylic groups or phenolic resins of low molecular weight condensates have been found to dissolve in low pH developers but at a slower rate than the first layer and therefore can also be used as top layers for dual layer plates developable in low pH developer.

A slower solubility rate of solubility in the developer of the masking layer than the first layer may also be achived by using polymers in the top layer which undergo slow hydrolysis and then become soluble in the developer. Examples of such polymers are styrene maleic anhydride copolymers.

According to another embodiment top layers can also be made to resist developer attack through inhibition of phenolic resins and are rendered soluble in the developer by "de-inhibition" upon IR irradiation.

Suitable phenolic resins include e.g. novolaks, resols, acrylic resins with phenolic side chains and polyvinyl phenolic resins, whereby novolaks are especially preferred. Novolak resins are condensation products of suitable phenols, e.g. phenol itself, C-alkyl-substituted phenols (including cresols, xylenols, p-tert-butylphenol, p-phenylphenol and nonylphenols), and of diphenols (e.g. bisphenol-A), with suitable aldehydes such as formaldehyde, acetaldehyde, propionaldehyde and furfuraldehyde. The type of catalyst and the molar ratio of the reactants determine the molecular structure and thus the physical properties of the resin. An aldehyde/phenol ratio of about 0.5:1 to 1:1, preferably 0.5:1 to 0.8:1, and an acid catalyst are used in order to produce those phenolic resins known as "novolaks" which have a thermoplastic character. As used in the present application, however, the term "novolak resin" should also encompass the phenolic resins known as "resols" which are obtained at higher aldehyde/phenol ratios and in the presence of alkaline catalysts.

One type of such top layers comprises for example a polymer like a novolak which itself is soluble/dispersible in an aqueous alkaline developer and an "insolubilizer" which reduces the solubility/dispersibility to such a high degree that the layer is not soluble or penetrable under developing conditions. The interaction between the polymer and the inhibitor is deemed to be weakened by IR radiation to such a degree that the irradiated (heated) areas of the layer are rendered soluble/dispersible in or penetrable by the developer. Such systems are for example described in US 6,352,811 and US 6,358,669. The polymer/insolubilizer systems can be the same as those described above for single layer plates.

The amount of insolubilizer(s) in the top layer is not particularly restricted as long as it reduces the aqueous alkaline developer solubility of the novolak. However, the solubility reduction has to take place to such an extent that when an aqueous alkaline developer is used, the heated areas of the coating are removed considerably faster than the non-heated areas. The insolubilizer is preferably present in an amount of at least 0.1 wt-% based on the dry layer weight, more preferred at least 0.5 wt-%, especially preferred at least 2 wt-% and particularly preferred at least 5 wt-%. Preferably, no more than 40 wt-%, more preferred no more than 25 wt-%, are used.

Another type of such top layers may comprise a polymer like a novolak which as such is soluble/dispersible in an aqueous alkaline developer but which has been chemically modified (for instance by chemically binding an "insolubilizer") so that it is not soluble/dispersible/penetrable by an aqueous alkaline developer. Such functionalized resins (like e.g. functionalized novolaks) are for instance described in US 2002/0,150,833 A1, US 6,320,018 B and US 6,537,735 B.

It is assumed that either there are any interactions within the top layer which are weakened by IR radiation or microcracks and/or bubbles are formed in the top layer or in the interface between first layer and top layer due to exposure to IR radiation (and the heat created thereby) which allows removal of the initially insoluble/inpenetrable top layer together with the soluble bottom layer by the developer in the exposed areas enabling the developer to penetrate and remove the imaged areas which also ultimately dissolve in the developer.

Chemically modified polymers useful for the top layer are for instance functionalized novolaks like those of formula (XIV) mentioned above and functionalized phenolic resins like those mentioned in US 6,537,735 B (e.g. tosylated novolaks), see also above under the headline "Single-layer plates". Modified alkylphenol resins (like those commercially available from Schenectady under the trade name SP1077 and HRJ302) as well as novolaks based on xylenol and cresol (like those commercially available from AZ-Electronics under the trade name SPN-572) are also useful for a top layer.

Other useful polymeric binders for the top layer include polyvinyl compounds having phenolic hydroxyl groups, including poly(hydroxystyrenes) and copolymers containing recurring units of a hydroxystyrene and polymers and copolymers containing recurring units of substituted hydroxystyrenes. Also useful are branched poly(hydroxystyrenes) having multiple branched hydroxystyrene recurring units derived from 4-hydroxystyrene as described for example in U.S. Patents 5,554,719 (Sounik) and 6,551,738 (Ohsawa et al.), and U.S. Published Patent Applications 2003/0050191 (Bhatt et al.) and 2005/0051053 (Wisnudel et al.), and in copending and commonly assigned U.S. Patent Application Serial No. 11/474,020 (filed June 23, 2006 by Levanon et al.). For example, such branched hydroxystyrene polymers comprise recurring units derived from a hydroxystyrene, such as from 4-hydroxystyrene, which recurring units are further substituted with repeating hydroxystyrene units (such as 4-hydroxystyrene units) positioned ortho to the hydroxy group. These branched polymers can have a weight average molecular weight (M_{w}) of from about 1,000 to about 30,000, or typically from about 1,000 to about 10,000, and more typically from about 3,000 to about 7,000. In addition, they may have a polydispersity less than 2 and preferably from about 1.5 to about 1.9. The branched poly(hydroxystyrenes) can be homopolymers or copolymers with non-branched hydroxystyrene recurring units.

One group of useful polymeric binders for the top layer include poly(vinyl phenol) and derivatives thereof. Such polymers are obtained generally by polymerization of vinyl phenol monomers, that is, substituted or unsubstituted vinyl phenols. Substituted vinyl phenol recurring units include those described below for the "a" recurring units in Structure (A).

Some vinyl phenol copolymers are described in EP 1,669,803A (Barclay et al.).

Other useful polymeric binders for the top layer are modified novolak or resole resins that are represented by Structure (B) 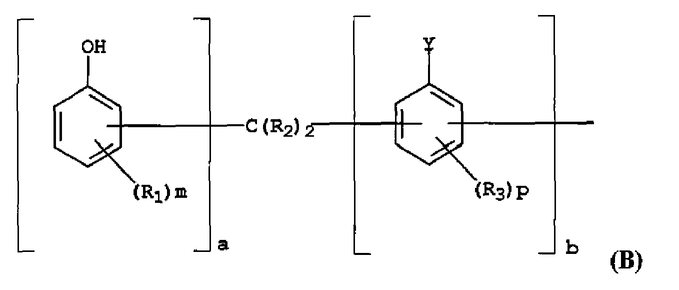 wherein
Y is 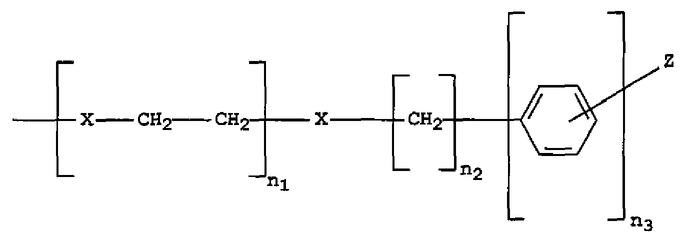 a is from about 90 to about 99 mol % (typically from about 92 to about 98 mol %) based on the total polymer, b is from about 1 to about 10 mol % (typically from about 2 to about 8 mol %), R₁ and R₃ are independently hydrogen or hydroxy, alkyl, or alkoxy groups, R₂ is hydrogen or an alkyl group, X is an alkylene, oxy, thio, -OC(=O)Ar-, -OC(=O)CH=CH-, or -OCO(CH₂)ₙ₄- group wherein Ar is an aryl group, m and p are independently 1 or 2, n₃ is 0 or an integer up to 5 (for example 0, 1, 2, or 3), n₂ is 0 or an integer up to 5 (for example, 0, 1, or 2), n₃ is 0 or 1 (typically 0), n₄ is at least 1 (for example, up to 8), and Z is -C(=O)OH, -S(=O)₂OH, -P(=O)(OH)₂, or -OP(=O)(OH)₂.

The alkyl and alkoxy groups present in the polymeric binders (for R¹, R², and R³) can be unsubstituted or substituted with one or more halo, nitro, or alkoxy groups, and can have 1 to 3 carbon atoms. Such groups can be linear, branched, or cyclic (that is, "alkyl" also include "cycloalkyl" for purposes of this invention).

When X is alkylene, it can have 1 to 4 carbon atoms and be further substituted similarly to the alkyl and alkoxy groups. In addition, the alkylene group can be a substituted or unsubstituted cycloalkylene group having at least 5 carbon atoms in the ring and chain. Ar is a substituted or unsubstituted, 6 or 10-membered carbocyclic aromatic group such as substituted or unsubstituted phenyl and naphthyl groups. Typically, Ar is an unsubstituted phenyl group.

In some embodiments, the polymeric binder of the top layer comprises recurring units represented by Structure (B) wherein a is from about 92 to about 98 mol %, b is from about 2 to about 8 mol % and Z is -C(=O)OH, and is present at a dry coverage of from about 15 to 100 weight % based on the total dry weight of the layer.

Other polymeric binders that may be in the top layer include phenolic resins such as novolak and resole resins, which include one or more pendant diazo, carboxylate ester, phosphate ester, sulfonate ester, sulfinate ester, or ether groups. The hydroxy groups of the phenolic resins can be converted to -T-Z groups in which T represents a polar group and Z represents a non-diazide functional group as described for example in U.S. Patent 6,218,083 (McCullough et al.) and WO 99/001795 (McCullough et al.). The hydroxy groups can also be derivatized with diazo groups containing o-naphthoquinone diazide moieties as described for example in U.S. Patents 5,705,308 (West et al.) and 5,705,322 (West et al.). Other useful polymeric binders include acrylate copolymers as described for example in EP 737,896A (Ishizuka et al.), poly(vinyl acetals) as described for example in WO 2005/039878 (Savariar-Hauck et al) DE 10 239 505 (Timpe et al.) and WO 2004081662 (Memetea et al.) and cellulose esters described in U.S. Patent 6,391,524 (Yates et al.).

Still other useful polymeric binders for the top layer are described for example, in U.S. Patents 7,163,770 (Saraiya et al.) and 7,160,653 gluing et al.).

The polymeric binder(s) can preferably be present in the top layer at a dry coverage of from about 15 to 100 wt-% (more preferably from about 30 to about 95 wt-%) based on the total dry top layer weight in those cases where no insolubilizer is present in the top layer; if an insolubilizer is present in the top layer, the polymeric binder(s) can be present preferably up to 99.9 wt-%, more preferably up to 99.5 wt-%, especially up to 98 wt-% and most preferably up to 95 wt-%.

### Optional components

Independently of whether the element is UV/VIS- or IR-sensitive, the radiation-sensitive coating can comprise one or more of the following optional components in addition to the essential components. If the coating consists of several layers, the optional component(s) can be present in one, several or all of the layers.

Dyes or pigments having a high absorption in the visible spectral range can be present in order to increase the contrast ("contrast dyes and pigments"). Particularly suitable dyes and pigments are those that dissolve well in the solvent or solvent mixture used for coating or are easily introduced in the disperse form of a pigment. Suitable contrast dyes include *inter alia* rhodamine dyes, triarylmethane dyes such as Victoria blue R and Victoria blue BO, crystal violet and methyl violet, anthraquinone pigments, azo pigments and phthalocyanine dyes and/or pigments. The colorants are preferably present in an amount of 0 to 15 wt-%, more preferred 0.5 to 10 wt-%, particularly preferred 1.5 to 7 wt-%, based on the dry layer weight.

Furthermore, the layer(s) can comprise surfactants (e.g. anionic, cationic, amphoteric or non-ionic tensides or mixtures thereof). Suitable examples include fluorine-containing polymers, polymers with ethylene oxide and/or propylene oxide groups, sorbitol-tri-stearate and alkyl-di-(aminoethyl)-glycines. They are preferably present in an amount of 0 to 10 wt-%, based on the dry layer weight, especially preferred 0.2 to 5 wt-%.

The layer(s) can furthermore comprise print-out dyes such as crystal violet lactone or photochromic dyes (e.g. spiropyrans etc.). They are preferably present in an amount of 0 to 15 wt-%, based on the dry layer weight, especially preferred 0.5 to 5 wt-%.

Also, flow improvers can be present in the layer(s), such as poly(glycol)ether-modified siloxanes; they are preferably present in an amount of 0 to 1 wt-%, based on the dry layer weight.

The layer(s) can furthermore comprise antioxidants such as e.g. mercapto compounds (2-mercaptobenzimidazole, 2-mercaptobenzthiazole, 2-mercaptobenzoxazole and 3-mercapto-1,2,4-triazole), and triphenylphosphate. They are preferably used in an amount of 0 to 15 wt-%, based on the dry layer weight, especially preferred 0.5 to 5 wt-%.

### Overcoat

An overcoat can be applied over a photopolymerizable coating of negative working precursors for protecting the coating from atmospheric oxygen during storage, exposure and in particular during the time between exposure and further processing. During that time the overcoat has to exhibit sufficient adhesion to the light-sensitive coating so that safe handling (manufacture, packing, transport, exposure etc.) is guaranteed without tearing of the layers. In addition to its function as oxygen barrier layer the overcoat also protects the photopolymerizable coating from fingerprints and mechanical damage like scratches.

A number of water-soluble polymers are described in the literature as being suitable for such overcoats. Suitable examples are polyvinyl alcohol, partly saponified polyvinyl acetate which can also contain vinylether and vinylacetal units, polyvinyl pyrrolidone and copolymers thereof with vinyl acetate and vinyl ethers, hydroxy alkyl cellulose, gelatin, polyacrylic acid, gum arabic, polyacryl amide, dextrin, cyclodextrin, copolymers of alkylvinyl ethers and maleic acid anhydride as well as water-soluble high molecular polymers of ethylene oxide having molecular weights of above 5,000 are particularly suitable. Polyvinyl alcohol is a preferred overcoat polymer. Also polyvinyl alcohol in combination with poly(1-vinyl-imidazole) or a copolymer of 1-vinyl-imidazole and at least one further monomer as described in WO 99/06890 can be used.

Polyvinyl alcohol can also be used in combination with polyvinyl pyrrolidone as adhesive.

Overcoats are also described in US 3,458,311, US 4,072,527, US 4,072,528, EP 275 147 A1, EP 403 096 A1, EP 354 475 A1, EP 465 034 A1 and EP 352 630 A1.

In a preferred embodiment the overcoat comprises polyvinyl alcohol or polyvinyl alcohol in combination with poly(1-vinylimidazol) (or a copolymer thereof).

Suitable polyvinyl alcohols are commercially available at inexpensive prices. They usually have a residual content of acetate groups in the range of 0.1 to 30 wt-%. Especially preferred are polyvinyl alcohols obtained from polyvinylacetate with a residual acetate content of 1.5 to 22 wt-%. By means of the molecular weight of the used polyvinyl alcohols, adhesion and water-solubility of the overcoats can be controlled. A lower molecular weight promotes the removal of the overcoat with aqueous solutions.

The water-soluble overcoats can be applied by means of surface coating methods known to the skilled practician such as doctor blade coating, roller coating, slot coating, curtain coating, spray or dipping processes. Dry layer weights of from 0.05 to 10 g/m², more preferably 0.2 to 3 g/m², most preferably 0.3 to 1 g/m² are suitable.

In many cases it is favorable to apply the water-soluble overcoats in an aqueous solution. This has the least detrimental effects on the environment and the human body.

For some applications, however, it can also be favorable to use organic solvents. In some substrates the addition of 0.5 to 60 wt-% of an organic solvent to the aqueous coating solution improves adhesion. By means of a slight solvation of the surface to be overcoated, the adhesive effect of the polymers of the overcoats according to the present invention is increased further. Such additives to solvents can e. g. be alcohols or ketones.

For a uniform and rapid wetting of the surface to be coated, anionic, cationic or non-ionic wetting agents may be added to the coating solutions. The overcoat furthermore can comprise stabilizers, preservatives, dyeing agents, foam separators and rheological additives.

### IMAGING

### IMAGEWISE EXPOSURE

If the absorber component used in the photopolymerizable coating absorbs UV/VIS radiation, the precursors are imagewise exposed in a manner known to the person skilled in the art with UV/VIS radiation of a wavelength of about 250 to about 750 nm. For this purpose, common lamps, such as carbon arc lamps, mercury lamps, xenon lamps and metal halide lamps, or lasers or laser diodes can be used. UV laser diodes emitting UV radiation in the range of about 405 nm (e.g. 405 ± 10 nm), argon ion lasers emitting in the visible range (488 nm or 514 nm) and frequency-doubled fd:Nd:YAG lasers emitting at around 532 nm are of particular interest as a radiation source. The laser radiation can be digitally controlled via a computer, i.e. it can be turned on or off so that an imagewise exposure of the plates can be effected via stored digitized information in the computer; this way, so-called computer-to-plate (ctp) printing plates can be obtained.

If the absorber component absorbs IR radiation, i.e. noticeably absorbs radiation of a wavelength in the range of more than about 750 to about 1,200 nm, and preferably shows an absorption maximum in this range in its absorption spectrum, imagewise exposure can be carried out with IR radiation sources. Suitable radiation sources are e.g. semi-conductor lasers or laser diodes which emit in the range of about 750 to about 1200 nm, for example Nd:YAG lasers (1,064 nm), laser diodes which emit between about 790 and about 990 nm, and Ti:sapphire lasers. The laser radiation can be digitally controlled via a computer, i.e. it can be turned on or off so that an imagewise exposure of the plates can be effected via stored digitized information in the computer; this way, so-called computer-to-plate (ctp) printing plates can be obtained. Any image-setters equipped with IR lasers that are known to the person skilled in the art can be used.

"Thermal plates" usually contain a photothermal conversion material (which absorbs radiation of a certain wavelength, and converts it to heat) and in most cases are sensitive to IR radiation. It is, however, also possible to directly apply heat in an imagewise manner (for instance by using a thermoprinting head).

The imagewise exposed precursor comprises exposed and unexposed areas of the coating. Depending on whether the precursor was positive working or negative working, the exposed areas correspond to non-image areas or image areas.

Any embodiment described with respect to the imagewise exposure can be combined with any suitable embodiment of the invention described above or below with respect to other aspects of the invention.

### DEVELOPING THE EXPOSED PRECURSOR

After exposure the precursor is treated with a developer in order to remove the coating in the non-image areas thereby revealing the substrate in said areas; if the precursor was a positive working one, the non-image areas correspond to the exposed areas while for negative working precursors the non-image areas correspond to the unexposed areas. According to one embodiment a preheat step is carried out between exposure and treating with the developer.

If the precursor comprises an overcoat which protects the radiation sensitive coating, the overcoat can be removed by washing/rinsing with water before applying the developer.

After removing the non-image areas of the coating (and optionally the overcoat) with the developer, the treated precursor can be dried.
According to one embodiment the treated precursor can be rinsed with water after removing the non-image areas of the coating (and optionally the overcoat) with the developer.

Typically, the exposed precursor is contacted with the developer by rubbing or wiping the imageable layer with an applicator containing this liquid. Alternatively, the exposed precursor may be brushed with the developer or the developer may be applied to the precursor by spraying. The treatment with the developer can also be carried out by immersing the exposed precursor in a bath of the developer. According to one embodiment, the processing may be carried out in a commercially available processor, equipped with an immersion type developing bath, a section for rinsing with water, a gumming section, and a drying section, can be used. Additionally, a conductivity-measuring unit can be incorporated into the processor for controlling the developer activity of the developer.

The exposed precursor is typically treated with the developer at a temperature of 18°C to about 28°C, for a period of about 5 seconds to about 60 seconds.

After a certain number of exposed precursors have been processed, the developing activity (for instance measured by titration or conductivity measurement) of a developer bath falls below a predetermined level. Then fresh developer is added to the bath (also called "top-up" process). Usually about 20 mL to about 200 mL, typically about 30 to 120 mL, of fresh developer per 1 m² of precursor processed is necessary to keep both the volume of developer and its activity/conductivity value constant. The processed lithographic printing plate, comprises regions in which imageable layer has been removed revealing the underlying surface of the hydrophilic substrate, and complimentary regions in which the imageable layer has not been removed. The regions in which the imageable layer has not been removed are ink receptive.

Instead of adding fresh developer for keeping the activity of the developer bath constant a so-called replenisher can be added. The replenisher suitably differs from the fresh developer in that the concentration of the alkaline reagent is higher compared to the concentration of the alkaline reagent in the fresh developer used; the concentration of the other components might be the same or higher as in the fresh developer.

After having contacted the precursor with the developer any excess of said developer remaining on the precursor can be removed for instance by means of squeeze rollers; washing/rinsing the precursor with a liquid like water etc. is also possible.

The developer used in the present invention is not particularly limited, but any developer which is capable of removing the non-image areas can be used; usually the developer is an aqueous alkaline solution. Said aqueous alkaline solution can for instance contain an alkali metal silicate, an alkali metal hydroxide or carbonate or phosphate for obtaining a pH of >6, preferably 8-14. The developer can optionally also contain a small amount of an organic solvent, a surfactant, a thickener, dyes, odorants, polymers, oligomers, antioxidants and mixtures thereof.

Any embodiment described with respect to the developing can be combined with any suitable embodiment of the invention described above or below.

### ALTERNATIVE IMAGING POSSIBILITIES

Instead of overall coating a substrate and removing the non-image areas thereafter by imagewise exposure and development the printing image areas of a lithographic printing plate may also be applied imagewise to a substrate thereby avoiding the necessity of exposure and development.

Furthermore, it is possible that imagewise exposure of positive working thermal plates to the radiation of an IR laser results in ablation of the non-image areas so that no developing step is required.

Such types of plates can also be subjected to gumming with a nano-particle containing composition according to the present invention.

### GUMMING TREATMENT

For the gumming treatment of the imaged lithographic printing plate (obtained either by imagewise exposure and development or by imagewise applying printing areas to the substrate) according to the present invention a gumming composition containing nanoparticles is prepared. This solution is then applied using common coating processes such as e.g. manual application by a sponge, dip coating, roller coating, spray coating, coating with a doctor blade or squeezing rolls and coating with a slot coater. The composition used in this process has a temperature of preferably 20 to 90°C. The gumming according to the present invention can also be carried out in the gumming section of a plate developing machine ("processor"). The viscosity of the gumming composition is not particularly restricted, however, it can influence the selection of the coating process (and vice versa).

The printing plate treated with the gumming composition is then dried, for example in the air or by means of a hot-air dryer or an infrared dryer. Drying is preferably carried out at a temperature of 20 to 120°C, especially preferred 20 to 80°C.

The gumming solution can be applied onto a printing plate immediately after imaging, i.e. before the printing plate is used for printing. This way, the surface of the printing plate is protected in case the plate is not used for printing immediately after imaging but stored for a certain amount of time.

The gumming solution can also be applied onto a printing plate that has already been used for printing. This is especially advisable if the printing machine is stopped for a prolonged period of time during printing, for example over the weekend.

The gumming thickness is usually at most 3 µm. Depending on the application method, the solids content of the gumming and the type of plate, the wet weight of the gumming is about 50 to 500 mg/m².

The gummed printing plates can be stored for several months before they are (again) mounted in the printing machine and used for printing. In practical applications, gummed printing plates are usually stored for about a week.

Any embodiment described with respect to the gumming treatment can be combined with any suitable embodiment of the invention described above or below with respect to other aspects of the invention.

### Aqueous Gumming Composition

A gumming composition to be used in a process according to the invention comprises water, nanoparticles and at least one member selected from surfactants and hydrophilic film-forming polymers. According to a preferred embodiment, the gumming composition - in addition to water and nanoparticles - comprises at least one hydrophilic film-forming polymer or surfactant, and especially preferred at least one hydrophilic film-forming polymer and at least one surfactant.

### Water

Tap water, deionized water or distilled water can be used. The amount of water is preferably in the range of 45 to 98 wt-%, based on the total weight of the gumming composition, especially preferred 50 to 95 wt-% and particularly preferred 80 to 95 wt-%.

### Nanoparticles

The particles (also referred to as "nanoparticles") used in the gumming composition according to this invention are inorganic and thus do not include organic polymeric particles; furthermore, the particles are non-metallic.

In addition, the useful particles are "inert" meaning that they do not have appreciable surface reactivity (surface reactive groups). Thus, the particles do not react with any of the other components of the gumming composition of the components of imagewise coating of the imaged printing plate to any appreciable extent. Such reactivity is not needed for providing the desired properties of this invention.

After drying the applied gumming composition the particles are generally discrete particles, meaning that they are uniformly dispersed throughout the surface of the imaged printing plate. There is generally only little clumping or agglomerations. To achieve such uniform dispersions, the particles can be mixed well into the gumming composition using e.g. a ball mill, sand mill, high-shear fluid flow mill, or other well known mixing techniques. With the selection of appropriate additives, stable dispersions of the particles can be obtained in desired proportions.

The inorganic, non-metallic, inert particles generally have an average particle size of from about 1 nm to about 0.5 µm, typically from about 10 to about 350 nm, preferably from about 100 to about 300 nm.

The average particle size within this application is the average equivalent diameter, and is defined as the diameter where 50 wt-% of the particles have a larger equivalent diameter, and the other 50 wt-% have a smaller equivalent diameter. Hence the average particle size is sometimes denoted as equivalent d50.

The primary particles' average size can for instance be determined by using electron micrographs of the product to be analyzed. The diameters of e.g. 3000-5000 particles are semi-automatically measured. For the measurement of the diameter, only those primary particles are considered where at least one half of the circumference is recognizable.

Up to now, the most popular piece of equipment for determining the primary particle size distribution is the TGZ 3 (particle size analyzer) developed by ENDTER and GEBAUER.

Particles that are useful in the practice of this invention include but are not limited to, particles of silica, aluminum oxide, and titanium dioxide. There are a number of commercial sources for such particles of the desired size. For example, useful silica particles can be obtained as Aerosil R9200 hydrophobic fumed silica and as numerous aqueous dispersions such as WS 1824 from Evoniks. Useful particles of aluminum oxide can be obtained as the commercial product A-Mite^{™} that is available from American Elements (Los Angeles, CA), and useful titanium dioxide particles are described for example, in U.S. Patent 6,974,611 (Sakatani et al.).

The amount of the nanoparticles is not specifically limited; preferably it is from 0.5 to 20 wt% based on the total weight of the gumming composition, more preferably from 1 to 10 wt%.

### Hydrophilic film forming polymer

Examples of suitable polymers are gum arabic, pullulan, cellulose derivatives such as hydroxymethyl celluloses, carboxymethylcelluloses, carboxyethylcelluloses or methylcelluloses, starch derivatives like (cyclo)dextrins, poly(vinyl alcohol), poly(vinyl pyrrolidone), polyhydroxy compounds like polysaccharides, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid and acrylamidopropane sulfonic acid, polyhydroxy compounds and starch derivatives.

Polyhydroxy compounds and starch derivatives are especially preferred. The starch derivative should be water-soluble, preferably cold-water-soluble and is selected from starch hydrolysis products such as dextrins and cyclodextrins, starch esters, such as phosphate esters and carbamate esters, starch ethers, such as e.g. cationic starch ethers and hydroxypropyl ethers, carboxymethyl starch and acetylated starch; from the above derivatives dextrins (including dextrin comprising sodium tetraborate and available as borax dextrin from Emsland Stärke GmbH) are preferred.

The starch used as a starting product for the starch derivatives can be of various origins, it can e.g. be obtained from corn, potatoes, rye, wheat, rice, manioc, tapioca, chestnuts or acorns; corn starch and potato starch are preferred.

Suitable water-soluble polyhydroxy compounds can be represented by the following structure (XV):

R¹(CHOH)ₙR² (XV)

in which n is 4 to 7; and
either (i) R¹ is hydrogen, aryl, or CH₂OH; and R² is hydrogen, an alkyl group having 1 to 4 carbon atoms, CH₂OR³ in which R³ is hydrogen or an alkyl group having 1 to 4 carbon atoms, CH₂N(R⁴R⁵) in which R⁴ and R⁵ are each independently hydrogen or an alkyl group having 1 to 4 carbon atoms, or CO₂H,
or (ii) R¹ and R² together form a carbon--carbon single bond; such compounds are for instance described in EP 1 868 036 A1.

One group of polyhydroxy compounds includes the sugar alcohols, compounds of the structure H(CHOH)ₙH; preferred sugar alcohols include mannitol, sorbitol, xylitol, ribitol, and arabitol, also included are, for example, talitol, dulcitol, and allodulcitol.

In another group of polyhydroxy compounds, R¹ and R² together form a carbon-carbon single bond resulting in carbocyclic compounds of the structure: (CHOH)ₙ, in which n is 4 to 7; preferably 5 or 6, more preferably 6.

In another group of polyhydroxy compounds, R¹ is hydrogen, aryl, or CH₂OH; and R² is an alkyl group having 1 to 4 carbon atoms, CH₂OR³ in which R³ is an alkyl group having 1 to 4 carbon atoms, CH₂N(R⁴R⁵) in which R⁴ and R⁵ are each independently H or an alkyl group having 1 to 4 carbon atoms, or CO₂H.

In another group of polyhydroxy compounds, R¹ is hydrogen or CH₂OH; and R² is CO₂H. More preferably, R¹ is H and n is 4 or 5. This group includes polyhydroxy compounds of the structure H(CHOH)ₙCO₂H, in which n is 4 or 5.

Another useful hydrophilic polymer comprises
(m1) primary, secondary and/or tertiary amino groups, and
(m2) acid groups selected from -COOH, -SO₃H, -PO₂H₂ and PO₃H₂, and
(m3) optionally alkylene oxide units -CHR¹-CH₂-O)ₚ-, wherein each R¹ independently represents H or -CH₃ and p is an integer from 1 to 50.

The acidic functional groups present in the hydrophilic polymer can all be in the form of a free acid, or all of said groups are in the form of a salt, or a part thereof is in the form of a free acid and the remaining part is in the form of a salt. When reference is made to the acidic functional group(s) in connection with the hydrophilic polymer this should include free acidic groups, salts and mixtures thereof unless defined otherwise.

Optionally the hydrophilic polymer comprises (m3) alkylene oxide units -(CHR¹-CH₂-O)ₚ- wherein each R¹ independently represents H or -CH₃ and p is an integer from 1 to 50. The alkylene oxide units can be present in the polymer backbone or in side chains, for instance as spacer between the backbone and the acid groups and/or amino groups.

The amino groups may be bound to the polymer backbone either directly or via a spacer; suitable spacers are for instance C₁-C₄ alkylene groups. It is preferred within this group of polymers that the amino groups are directly bound to a carbon atom of the polymer backbone; for instance, the hydrophilic polymer comprises structural units with amino groups represented by the following formula 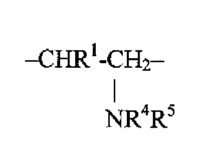 wherein R¹ is H or CH₃ and R⁴ and R⁵ are independently selected from H, alkyl, aryl, and alkylaryl.

Alternatively, the nitrogen atom of the amino groups is not part of a side chain but is part of the polymer backbone; such hydrophilic polymers can for instance comprise the following structural units (A1) in the backbone: 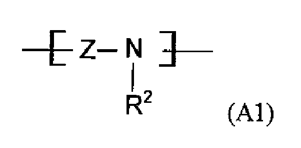 wherein Z is a straight chain or branched C₁-C₃ (preferably C₁-C₂) alkylene group and each R² independently represents H, C₁-C₄ alkyl, phenyl or X-AG with each X being independently selected from divalent straight chain or branched saturated or unsaturated hydrocarbons (e.g. C₂-C₆ alkylene and arylene), alkylene oxide including polyalkylene oxide, and ethylene imine including polyethylene imine, and each -AG independently representing an acid group as defined above. If the amino group in (A1) is a terminal amino group, a second R² as defined above is present; it is also possible that an additional third R² is bound resulting in a quaternized nitrogen atom.

Spacer X is perferably a poly(alkylene)oxide or a poly(ethylene)imine.

If more than one unit (A1) is present in a polymer molecule, each Z and each R² is independently selected from the members given above.

The acid groups may be bound to a carbon atom of the polymer backbone either directly or via a spacer like C₁-C₄ alkylene. For instance, the structural unit of the polymer comprising the acid group is represented by the following formula: 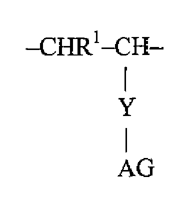 wherein R¹ is H or CH₃, Y is a single bond or a spacer, and AG is an acid group selected from -COOH, -SO₃H, -PO₂H₂ and -PO₃H₂, preferably -COOH.

Preferred spacers Y are alkyleneoxide, poly(alkylene)oxide, poly(ethylene)imine, ring opened lactones, ring opened lactames, ring opened anhydrides and carboxylic acids, and CₓH₂ₓ (x=1-6); especially preferred are poly(alkylene)oxide spacers.

Alternatively, the acid groups may be bound to the nitrogen atoms of the amino groups via a spacer; it is preferred that in this case the nitrogen atom is part of the polymer backbone as shown in unit (A1) above and further exemplified in unit (A1'): 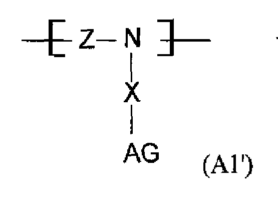 with Z, X and AG being as defined above.

Examples of the hydrophilic polymers containing units (m1) and (m2) are derivatives of polyethylene imine or polyvinyl amine comprising acid groups AG.

Another type of useful hydrophilic polymer comprises structural units derived from the following compounds:
(x1) at least one compound comprising both polyalkylene oxide chains and at least one structural unit which is free-radical polymerizable,
   and
(x2) at least one monomer capable of copolymerizing with the free-radical polymerizable structural unit of (x1) and furthermore comprising at least one functional group with pKₛ<5, wherein the acidic functional group(s) can be present as a free acid group or in the form of a salt; preferably the acidic functional groups are selected from a carboxylic acid group, a sulfonic acid group, a phosphonic acid group and a phosphoric acid group as well as mixtures thereof.

Optionally, the polymer can also comprise structural units derived from at least one comonomer (x3) different from monomers (x1) and (x2), which comprises at least one free-radical polymerizable group but neither a polyalkylene oxide chain nor a functional group with pKₛ <5. By means of comonomer (x3), physical properties, such as e.g. solubility in H₂O, can be adjusted.

The compound (x1) preferably comprises polyethylene oxide and/or polypropylene oxide chains; within the framework of the present invention, the prefix "poly" also encompasses oligomers.

The free-radical polymerizable structural unit of compound (x1) is preferably derived from acrylic acid and/or methacrylic acid. The term "(meth)acrylic acid" encompasses both acrylic acid and methacrylic acid; analogously, the same applies to "(meth)acrylate".

Suitable examples of compound (x1) include:
Poly(ethylene glycol) methacrylate,
poly(ethylene glycol) acrylate,
poly(propylene glycol) methacrylate,
poly(propylene glycol) acrylate,
monoesters of acrylic acid or methacrylic acid with block copolymers of ethylene oxide and propylene oxide,
the reaction product of 2,4-toluene diisocyanate-terminated polyethylene glycol, polypropylene glycol, block copolymer of polyethylene glycol and polypropylene glycol or statistical poly(ethylene glycol-propylene glycol) copolymer with hydroxyalkyl acrylate or methacrylate (for example hydroxyethyl acrylate or methacrylate) or allyl alcohol,
the monoreaction product of isocyanatoalkyl acrylate or methacrylate (in particular isocyanatoethyl acrylate or methacrylate) with polyethylene glycol, polypropylene glycol, block copolymer of polyethylene glycol and polypropylene glycol or statistical poly(ethylene glycol-propylene glycol) copolymer,
ester or ether derivatives of poly(alkylene glycol) acrylate and methacrylate (in particular of poly(ethylene glycol) acrylate and methacrylate).

Preferred examples of compound (x1) include
Poly(ethylene glycol) acrylate, poly(ethylene glycol) methacrylate, alkyl ethers of poly(ethylene glycol) acrylate, alkyl ethers of poly(ethylene glycol) methacrylate, poly(propylene glycol) acrylate and poly(propylene glycol) methacrylate, and poly(ethylene glycol) (meth)acrylate phosphoric acid monoesters; especially preferred are poly(ethylene glycol) acrylate, poly(ethylene glycol) methacrylate, and poly(propylene glycol) methacrylate.

Suitable examples of monomer (x2) include acrylic acid, methacrylic acid, crotonic acid, maleic acid anhydride ring-opened with a C₁-C₆ alkanol, vinylbenzoic acid, vinylphosphonic acid, vinylsulfonic acid, vinylbenzolsulfonic acid, monoesters of phosphoric acid with hydroxyalkyl(meth)acrylate (in particular hydroxyethyl methacrylate and hydroxyethyl acrylate) or allyl alcohol, monoesters of phosphoric acid with ethylene glycol (meth)acrylate or propylene glycol (meth)acrylate, monoesters of phosphoric acid with poly(ethylene glycol) (meth)acrylate or poly(propylene glycol) (meth)acrylate, and sulfopropyl (meth)acryloylethyldialkylammoniumhydroxide; especially preferred are (meth)acrylic acid, vinylphosphonic acid, the monoester of phosphoric acid with either hydroxyethyl(meth)acrylate or poly(ethylene glycol) (meth)acrylate, and (meth)acryloyl dimethyl-(3-sulfopropyl)-ammoniumhydroxide.

Suitable examples of optional comonomer (x3) include (meth)acrylamide, N-vinylpyrrolidone, vinyl acetate, hydroxyalkyl(meth)acrylate (in particular hydroxyethyl acrylate and hydroxyethyl methacrylate), allyl alcohol and N-vinylimidazole, as well as mixtures thereof.

The molar ratio of compounds (x1), (x2) and optionally (x3) is not particularly restricted. Preferably, the structural units derived from (x1) account for 5 to 95 wt-% of the hydrophilic polymer, based on all the structural units, especially preferred 20 to 80 wt-%. Preferably, the structural units derived from (x2) account for 5 to 95 wt-% of the hydrophilic polymer, based on all the structural units, especially preferred 20 to 80 wt-%. Preferably, the optional structural units derived from (x3) account for 0 to 50 wt-% of the hydrophilic polymer, based on all the structural units, especially preferred 0 to 30 wt%.

The copolymerization of compound (x1), monomer (x2) and optionally comonomer (x3) is preferably carried out in solution. Organic solvents or solvent mixtures, water, or mixtures of water and an organic solvent miscible with water can be used for this purpose. Preferably, both the starting components (x1), (x2) and optionally (x3) and the product are soluble therein. According to one embodiment, a solvent with negligible vapor pressure (i.e. the vapor pressure cannot be measured by means of commercially available osmometers) is used (such a solvent is also referred to as a "green solvent"), such as an ionic liquid; for more information on "green solvents" see "Ionic Liquids as Green Solvents: Progress and Prospects" by Robin D. Rogers and Kenneth R. Seddon, in ACS Symposium Series No. 856 and "Ionic Liquids in Synthesis" by Peter Wasserscheid and Thomas Welton, Wiley - VCH 2003.

According to one embodiment of the invention the gumming composition comprises a dextrin as hydrophilic polymer.

The amount of the hydrophilic film forming polymer is not specifically limited; preferably it is from 0 to 30 wt-% based on the total weight of the gumming composition, more preferably from 1 to 20 wt-%.

### Surfactant

The gumming composition used in the present invention may comprise a surfactant.

The surfactant is not specifically limited as long as it is compatible with the other components of the finisher and soluble in the finisher solution. The surfactant can be a cationic, an anionic, an amphoteric or a nonionic one.

Examples of anionic surfactants include hydroxyalkanesulfonates, alkylsulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyoxyethylenealkylethers, salts of phosphoric esters of polyoxyethylenealkylphenylethers, partially saponified compounds of styrenemaleic anhydride copolymers, partially saponified compounds of olefin-maleic anhydride copolymers, naphthalenesulfonateformalin condensates, sodium dodecylphenoxybenzene disulfonates, the sodium salts of alkylated naphthalenesulfonate, disodium methylene-dinaphtalene-disulfonate, sodium dodecyl-benzenesulfonate, (di)sulfonated alkyldiphenyloxides, ammonium or potassium perfluoroalkylsulfonates and sodium dioctylsulfosuccinate.

Particularly preferred among these anionic surfactants are alkylnaphthalenesulfonates, disulfonated alkyldiphenyloxides, and alkylsulfonates.

Suitable examples of the nonionic surfactants include polyoxyethylene alkyl ethers, polyoxyethylene phenyl ethers, polyoxyethylene 2-naphthyl ethers, polyoxyethylene alkyl phenyl ethers, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycol monoaliphatic esters, partial esters of sucrose aliphatic acids, partial esters of polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, tri-ethanolaminealiphatic esters, and trialkylamine oxides. Particularly preferred among these nonionic surfactants are polyoxyethylene phenyl ethers and polyoxyethylene 2-naphthyl ethers.

Further, fluorinic and siliconic anionic and nonionic surfactants may be similarly used.

Amphoteric surfactants are for example N-alkylamino acid triethanol ammonium salts, cocamidopropyl betaines, cocamidoalkyl glycinates, sodium salt of a short chain alkylaminocarboxylate, N-2-hydroxyethyl-N-2-carboxyethyl fatty acid amidoethylamin sodium salts, and carboxcylic acid amidoetherpropionates; preferred are cocamidopropylbetaines.

Examples of cationic surfactants are tetraalkyl ammoniumchlorides like tetrabutyl ammoniumchloride and tetramethyl ammoniumchloride, and polypropoxylated quaternary ammonium chlorides.

Nonionic, anionic and amphoteric surfactants as well as mixtures thereof are preferred.

Two or more of the above surfactants may be used in combination. The amount of the surfactant (or total amount of surfactants if more than one is used) is not specifically limited but is preferably from 0 to 20 wt-%, more preferably from 0.01 to 8 wt-% based on the total weight of the gumming composition.

### Optional components of the gumming composition

Besides the above-cited optional components the gumming composition used in the present invention may contain further additives like organic solvents, biocides, complexing agents, buffer substances, dyes, antifoaming agents, odorants, anticorrosive agents, thickening agents, acidic and alkaline components.

### Antifoaming agents:

Suitable antifoaming agents include e.g. the commercially available Silicone Antifoam Emulsion SE57 (Wacker), TRITON^{®} CF32 (Rohm & Haas), AKYPO^{®} LF (ethercarboxylic acid Chem Y), Agitan 190 (Münzing Chemie), TEGO^{®} Foamese 825 (modified polysiloxane, TEGO Chemie Service GmbH, Germany). Silicone-based antifoaming agents are preferred.

They are either dispersible or soluble in water. The amount of antifoaming agent in the developer is preferably 0 to 1 wt-%, based on the weight of the gumming composition especially preferred 0.01 to 0.5 wt-%. One antifoaming agent or a mixture of two or more can be used.

### Buffers:

Suitable buffer substances include e.g. tris(hydroxymethyl)-aminomethane (TRIS), hydrogen phosphates, glycine, 3-(cyclohexylamino)-propane sulfonic acid (CAPS), hydrogen carbonates, borates including borax, 2-amino-2-methyl-1-propanol (AMP), 3-(cyclohexylamino)-2-hydroxy-1-propane-sulfonic acid (CAPSO), and 2-(N-cyclohexylamino)ethan-sulfonic acid (CHES).

### Biocides:

The biocides should be effective against bacteria, fungi and/or yeasts. Suitable biocides include e.g. N-methylol-chloroacetamide, benzoic acid, p-hydroxybenzoic acid esters, phenol or its derivatives, formalin, imidazol derivatives, isothiazolinone derivatives like 1,2-benzisothiazolin-3-on, benzotriazole derivatives, amidines, guanidine derivatives, quaternary ammonium salts, pyridine, quinoline derivatives, diazine, triazole derivatives, oxazole and oxazine derivatives and mixtures thereof. Their amount is not particularly restricted and preferably accounts for 0 to 10 wt-%, based on the total weight of the gumming composition, especially preferred 0.1 to 1 wt-%. One biocide or a mixture of two or more can be used.

### Complexing agents:

Examples of suitable complexing agents include: Aminopolycarboxylic acid and salts thereof, such as ethylene diamine tetraacetic acid and potassium or sodium salts thereof, diethylene triamine pentaacetic acid and potassium or sodium salts thereof, triethylene tetraaminohexaacetic acid and potassium or sodium salts thereof, hydroxyethyl ethylene diamine triacetic acid and potassium or sodium salts thereof, nitrilotriacetic acid and potassium or sodium salts thereof, 1,2-diaminocyclohexane-tetraacetic acid and potassium or sodium salts thereof and 1,3-diamino-2-propanol-tetraacetic acid and potassium or sodium salts thereof, and an organophosphonic acid, phosphonoalkane tricarboxylic acid or salts thereof, such as 2-phosphonobutane-1,2,4-tricarboxylic acid and potassium or sodium salts thereof, phosphonobutane-2,3,4-tricarboxylic acid and potassium or sodium salts thereof, phosphonoethane-2,2,2-tricarboxylic acid and potassium or sodium salts thereof, aminotris-(methylenephosphonic acid) and potassium or sodium salts thereof and sodium gluconate. The complexing agents can be used individually or as a combination of two or more. Organic amine salts of the above-mentioned complexing agents can be used instead of the potassium or sodium salts thereof. The amount of complexing agent preferably accounts for 0 to 5 wt-% in the gumming composition, based on the total weight of the solution, especially preferred 0.01 to 1 wt-%.

### Solvents:

The gumming composition may also comprise an organic solvent or a mixture of organic solvents. The developer is a single phase. Consequently, the organic solvent must be miscible with water, or at least soluble in the gumming composition to the extent it is added to the composition, so that phase separation does not occur. The following solvents and mixtures of these solvents are suitable for use in the developer: the reaction products of phenol with ethylene oxide and propylene oxide, such as ethylene glycol phenyl ether; benzyl alcohol; esters of ethylene glycol and of propylene glycol with acids having six or fewer carbon atoms, and ethers of ethylene glycol, diethylene glycol, and of propylene glycol with alkyl groups having six or fewer carbon atoms, such as 2-ethylethanol and 2-butoxyethanol. A single organic solvent or a mixture of organic solvents can be used. The organic solvent is typically present in the gumming composition at a concentration of between about 0 wt-% to about 15 wt-%, based on the weight of the gumming composition preferably between about 3 wt-% and about 5 wt-%.

### Anticorrosive agents:

Examples of anticorrosive agents are phosphonic acids and their salts like hydroxyethyl phosphonic acid and its salts, amino trismethylene phosphonic acid and its salts, and diethylentriaminpentamethylene phosphonic acid and its salts; phosphates like trisodium phosphate; borates like borax; as well as glycerol and glycols having the formula 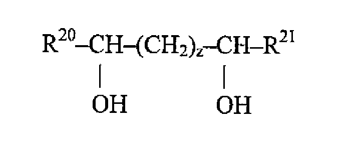 (wherein z is 0, 1 or 2 and R²⁰ and R²¹ are independently hydrogen or C₁-C₃ alkyl).

The anticorrosive agent or mixture of such agents is typically present in the gumming composition at a concentration of about 0 to 10 wt-% based on the weight of the gumming composition, preferably 0.1 to 5 wt-%, in case of glycerol or a glycol 5 to 10 wt-%.

### Further additives:

Odorants and dyes can also be present, if desired. The dyes are added in order to prevent confusion when different processing chemicals like developer, replenisher and finisher are used at the same time. Examples for classes of dyes that can be used are azo dyes, triarylmethan dyes or phthalocyanines. The concentration of the dyes in the gumming composition is typically 0 to 1 wt.-%, preferably 0.0005 to 0.5 wt.-% based on the gumming composition.
Odorants can be used in order to compensate unpleasant smell of other components in the gumming composition. The typical concentration of odorants is within 0.001 to 1 wt.-% based on the gumming composition.

### ALTERNATIVE PROCESSING POSSIBILITIES

As an alternative, instead of carrying out developing and gumming in two separate processing steps, it can be done in a single step (also referred to as "2 in 1 processing"). For doing so, a hydrophilic film forming polymer has to be added to an aqueous alkaline developer; according to one embodiment also (a) surfactant(s) is/are present in the developer. For such "2 in 1 processing" the hydrophilic film forming polymer is preferably for instance the polymer comprising structural units derived from (x1), (x2) and optionally (x3) described above. The "2 in 1 processing" can be carried out by hand or in a commercial processor.

The invention will be explained in more detail in the following examples; however, they shall not restrict the invention in any way.

### Examples

### Glossary

Sword Ultra is a commercial positive working thermal printing plate from Kodak Graphic Communications in Osterode.

Aerodisp^{®} W1714 is a SiO₂ aqueous dispersion with 14 wt.% solids, available from Evonik, Germany, d₅₀ = 0.16 µm

Aerodisp^{®} W 1824 is a SiO₂ aqueous dispersion with 24 wt.% solids, available from Evonik, Germany, d₅₀ = 0.2 µm

Aerodisp^{®} W1836 is a SiO₂ aqueous dispersion with 36 wt.% solids, available from Evonik, Germany, d₅₀ = 0.3 µm

850S is a commercial gumming composition from Kodak Graphic Communications which inter alia contains a dextrine, a surfactant and a complexing agent but does not contain nanoparticles 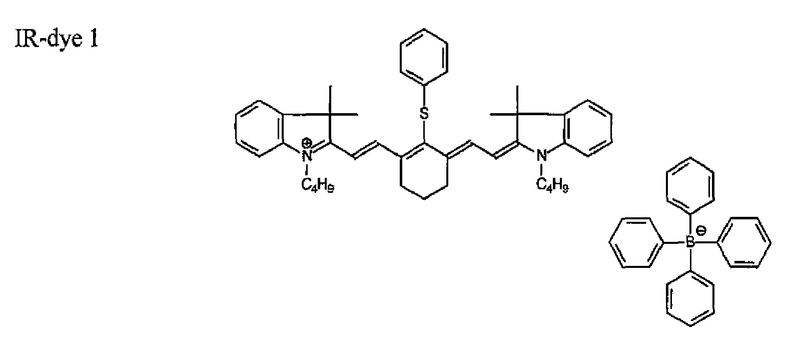
- binder 1: copolymer of benzyl methacrylate/allyl methacrylate/methacrylic acid (molar ratio 20/60/40)
- monomer 1: mixture of 1 part of NK-Ester BPE-200 (ethoxylated bisphenole A having methacrylic end groups available from Shin Nakamura/Japan) and 3 parts of a 80% solution in methyl ethyl ketone of an oligomer obtained by reacting Desmodur® N100 (trifunctional isocyanate = biuret of hexamethylene diisocyanate, available from Bayer/Germany) with hydroxyethyl acrylate and pentaerythritol triacrylate (amount of double bonds in the oligomer: 0.5 double bonds per 100 g, when all isocyanate groups have reacted)
- Kayamer PM-2: ester of 1 mol phosphoric acid and 1.5 mol hydroxyethylmethacrylate, available from Nippon Kayaku/Japan

### Gumming compositions and stability

The following gumming compositions were made and the stabilities of the dispersions were evaluated after 1 week of standing without agitation in a beaker.

**Table 1**

| Gum | Composition | nano-particles | Stability after 1 week |
|---|---|---|---|
| Gum A | 50 g of Aerodisp W1714 + 50g 850S | 7 wt% | stable |
| Gum B | 50 g of Aerodisp W1824 + 50g 850S | 12 wt% | stable |
| Gum C | 25 g of Aerodisp W1836 + 50g 850S + 25g Water | 9 wt% | stable |
| Reference 850S | 50 g 8505 + 50 g water | 0% | stable |

### Preparation of the gummed Plates

### Plates A-C (non-preheat CtP Thermal plates; positive working)

Sword Ultra Plates having a size of 380 x 640 mm and being denoted Plate A, B, C, were imagewise exposed at 120 mJ/cm² and developed in Goldstar Premium Developer at 23 °C and 1000 mm/min in a Mercury processor. Each of plates A-C was gummed in the processor with Gums A-C, respectively.

### Plate 1 (comparative)

A similar such plate was prepared as described for Plate A-C above with the exception that the plate was gummed with the Reference Gum 850S to give Plate 1.

### Plate D (no-preheat negative working digital thermal plate)

An electrochemically grained and anodized aluminum foil with an oxide weight of 3 g/m² was subjected to an after treatment using an aqueous solution of polyvinyl phosphoric acid. The average roughness of the surface was 0.55 µm. Coating compositions corresponding to Table 2 were applied to the substrate after filtering with a wire bar coater. The coatings were dried for 4 minutes at 90°C. The coatings weights were 1.4 g/m².

**Table 2**

| | |
|---|---|
| 32 ml | propylene glycol monomethyl ether |
| 8 ml | methyl ethyl ketone |
| 0.09 g | IR dye 1 |
| 2.28 g | binder 1 |
| 0.15 g | bis(4-cumyl)iodonium tetraphenylborate |
| 4.3 g | monomer 1 |
| 0.2 g | Kayamer PM-2 |
| 5.40 g | dispersion in propylene glycol monomethyl ether containing 9 wt% of copper phthalocyanine and 1 wt% of a polyvinylacetal binder containing 39.9 mol% units derived from vinyl alcohol, 1.2 mol% units derived from vinylacetate, 15.4 mol% acetal units derived from acetaldehyde, 36.1 mol% acetal units derived from butyraldehyde and 7.4 mol% acetal units derived from 4-formylbenzoic acid |
| 0.15 g | 1H-1,2,4-triazole-5-thiol |

The obtained sample was overcoated with an aqueous solution of poly(vinyl alcohol) (Celvol 203 from Air Products, having a hydrolysis degree of 88%) with a wire bar coater and dried for 4 minutes at 90°C to get a printing plate precursor. The coating weight of the poly(vinyl alcohol) overcoat was 1 g/m².

The lithographic plate thus obtained was imagewise exposed with Trendsetter 3244 from Kodak (830nm). After washing off the water-soluble overcoat with water the plate was developed and gummed in the Mercury processor using the commercial Kodak 980 developer and Gum B described above.

### Plate 2 (comparative)

A similar such plate was prepared as described under Plate D above with the exception that the plate was gummed with the Reference Gum 850S to give Plate 2.

### Plate E (digital UV sensitive plate, negative working)

An electrochemically (in HCl) grained and anodized aluminum foil was subjected to a treatment with an aqueous solution of polyvinyl phosphonic acid (PVPA) and after drying was coated with a solution as described in Table 3 and dried.

**Table 3**

| | |
|---|---|
| 1.02 g | of a terpolymer prepared by polymerization of 470 parts by weight styrene, 336 parts by weight methyl methacrylate and 193 parts by weight methacrylic acid, 30% solution in 1-methaxy-2-propanol |
| 0.1 g | Kayamer PM-2 (1 mole phosphoric acid esterified with 1.5 mole hydroxyethyl methacrylate from Coa Corp. Ltd., Japan) |
| 0.2 g | mercapto-3-triazole |
| 3.92 g | of an 80% methyl ethyl ketone solution of a urethane acrylate prepared by reacting Desmodur N 100^{®} (available from Bayer) with hydroxyethyl acrylate and pentaerythritol triacrylate; amount of double bonds: 0.5 double bonds per 100 g when all isocyanate groups have completely reacted with the acrylates containing hydroxy groups |
| 0.45 g | ditrimethylolpropane tetraacrylate |
| 1.25 g | of a dispersion in 1-methoxy-2-propanol comprising 7.25 wt.-% copper phthalocyanine and 7.25 wt.-% polyvinylacetal binder comprising 39.9 mole-% vinyl alcohol groups, 1.2 mole-% vinyl acetate groups, 15.4 mole-% acetal groups derived from acetaldehyde, 36.1 mole-% acetal groups derived from butyric aldehyde and 7.4 mole-% acetal groups derived from 4-formylbenzoic acid |
| 0.19 g | 2,2-bis-(2-chlorophenyl)-4,5,4',5'-tetraphenyl-2'H-[1,2']biimidazolyl |
| 0,7 g | 2-phenyl-4-(2-chlorophenyl)-5-(4-NN-diethylarninophenyl)-oxazole-1,3 |
| 20 ml | propyleneglycol monomethyl ether |
| 16 ml | methanol |
| 25 ml | methyl ethyl ketone |

The solution was filtered, applied to the lithographic substrate and the coating was dried for 4 minutes at 90°C. The dry layer weight of the photopolymer layer was about 1.5 g/m².

The obtained sample was coated with an overcoat by applying an aqueous solution of poly(vinylalcohol) (Airvol 203 available from Airproducts; degree of hydrolysis: 88%); after drying for 4 minutes at 90°C, the overcoat had a dry layer weight of about 3 g/m².

The printing plate precursor was exposed with a tungsten lamp having a metal interference filter for 405 nm through a gray scale having a tonal range of 0.15 to 1.95, wherein the density increments amount to 0.15 (UGRA gray scale) with 1 µW/cm². Immediately after exposure, the plate was heated in an oven for 2 minutes at 90°C.

Then, the exposed plate was treated for 30 seconds with a developer solution comprising the following components:
3.4 parts by weight Rewopol NLS 28^{®} (available from REWO)
1.1 parts by weight diethanol amine
1.0 parts by weight Texapon 842^{®} (available from Henkel)
0.6 parts by weight Nekal BX Paste^{®} (available from BASF)
0.2 parts by weight 4-toluene sulfonic acid and
93.7 parts by weight water

Then the developer solution was again rubbed over the surface for another 30 seconds using a tampon and then the entire plate was rinsed with water. After this treatment, the exposed portions remained on the plate. The plate was then gummed in the gumming section of the mercury processor using the gum B described above.

### Plate 3 (comparative)

A similar such plate was prepared as described under Plate E above with the exception that the plate was gummed with the Reference Gum 850S to give Plate 3.

### Plate F (preheat thermal plate, negative working)

An electrochemically grained and anodized aluminum foil with an oxide weight of 3 g/m² was subjected to an after treatment using an aqueous solution of polyvinyl phosphoric acid. The average roughness of the surface was 0.55 µm. Coating compositions corresponding to Table 4 were applied to the substrate after filtering with a wire bar coater. The coatings were dried for 4 minutes at 90°C. The coatings weights were 2,0 g/m².

**Table 4**

| | |
|---|---|
| 4.72 g | Terpol which is a 30% solution in MEK of a terpolymer made from Styrene 47 w%, Methylmethacrylate 33.6 w%, Methacrylic acid 19.3 w% |
| 1,4 g | Joncryl 683, acrylic resin from SC Johnson & Son Inc. USA, acid number = 162 mg KOH/g |
| 0,4 g | Crystal Violet (10 % in MeOH) |
| 3,2 g | urethane acrylate (80% solution in methyl ethyl ketone; prepared by reacting Desmodur® N100 with hydroxyethyl acrylate and pentaerythritol triacrylate; amount of double bonds: 0.5 double bonds per 100 g, when all isocyanate groups have reacted) |
| 0.10 g | phenylimino diacetic acid |
| 0.09 g | 2-[2-[2-thiophenyl-3-[2-(1,3-dihydro-1,3,3-trimethyl-2H-indole-2-ylidene)- ethylidene]-1-cyclohexene-1-yl]-ethenyl]-1,3,3-trimethyl-3H-indoliumchloride |
| 0.30 g | 2-(4-methoxyphenyl)-4,6-bis(trichloromethyl)-1,3,5-triazine |
| 0.30 g | 1H-1,2,4-triazole-5-thiol |
| 38 ml | propylene glycol monomethyl ether |
| 4 ml | methyl ethyl ketone |

The obtained sample was overcoated with an aqueous solution of poly(vinyl alcohol) (Celvol 203 from Air Products, having a hydrolysis degree of 88%) with a wire bar coater and dried for 4 minutes at 90°C to get a printing plate precursor. The coating weight of the poly(vinyl alcohol) overcoat was 1,8 g/m².

The lithographic plate thus obtained was imagewise exposed with Trendsetter 3244 from Kodak (830nm). Immediately after exposure, the plate was heated in an oven for 2 minutes at 90°C. After washing off the water-soluble overcoat with water the plate was developed and gummed in the Mercury processor using the commercial Kodak 980 developer and Gum B described above.

### Plate 4 (comparative)

A similar such plate was prepared as described under Plate F above with the exception that the plate was gummed with the Reference Gum 850S to give Plate 4.

### Scratch Tests

A strip of the plate having a size of 10 cm x 640 mm was cut out from each of the gummed plates and used as scratch probe. The rest of the gummed plate was mounted on a conveyor. The scratch probe was placed on the front end of the gummed plate and weighed down with a metal block (600g). The conveyor was started so that the weighted scratch probe is drawn over the gummed plate. The plate was then removed, rinsed with water and hand inked with Protection Ink 304. The number of scratches visible were then evaluated.

As it is usual practice at customer sites to either stack the plates with the front side facing each other or the back side facing the front, the scratch tests were conducted once using the printing surface to scratch the gummed plate and again with the aluminum side (back side) to scratch the gummed plate.

Scratch tests performed using the back side:

**Table 5**

| Plate | Gum | Number of scratches |
|---|---|---|
| Plate A | Gum A | 15 |
| Plate B | Gum B | 17 |
| Plate C | Gum C | 13 |
| Plate 1 | Standard Gum | 23 |
| | | |
| Plate D | Gum B | 7 |
| Plate 2 | Standard Gum | 15 |
| | | |
| Plate E | Gum B | 6 |
| Plate 3 | Standard Gum | 12 |
| | | |
| Plate F | Gum B | 5 |
| Plate 4 | Standard Gum | 10 |

Scratch tests performed using the front side:

**Table 6**

| Plate | Gum | Number of scratches |
|---|---|---|
| Plate A | Gum A | 2 |
| Plate B | Gum B | 3 |
| Plate C | Gum C | 4 |
| Plate 1 | Standard Gum | 15 |
| | | |
| Plate D | Gum B | 7 |
| Plate 2 | Standard Gum | 17 |
| | | |
| Plate E | Gum B | 3 |
| Plate 3 | Standard Gum | 10 |
| | | |
| Plate F | Gum B | 5 |
| Plate 4 | Standard Gum | 16 |

The scratch tests with certain plates comprising a gumming with nanoparticles clearly show that the number of scratches is significantly reduced compared to the same type of plate with standard gumming composition 850S without nanoparticles.

### Press Performance

Each of the plates with the respective gums were mounted on a Roland 500 press that was charged with a black ink (Sun Chemical Offset S7184). The aqueous fountain solution used was Combifix-XL (from Hostmann and Steinberg, Germany) 4% which contained 10% isopropylalcohol.

The printing press was started and the damping system was engaged to wet the printing plates with fountain solution. After a few revolutions, the inking system was engaged and 200 copies were printed. The printed sheets were assessed for number of sheets needed to print a clean background, number of sheets to get to full ink density, and general image quality. After printing 1000 copies, the press was stopped for 30 mins and then restarted by first inking before dampening was started. The number of sheets to obtain clean prints were noted.

For all the plates with the gums containing nanoparticles no adverse effect on clean background or image quality on the printed copies were seen.

## Claims

1. Process for improving the scratch-resistance of a lithographic printing plate, comprising:
applying an aqueous composition comprising inorganic, non-metallic, inert particles having an average particle size of from 1 nm to 0.5 µm, to an exposed and optionally developed lithographic printing plate precursor.

2. Process according to claim 1, wherein the aqueous composition is an aqueous alkaline developer further comprising at least one hydrophilic film-forming polymer, and wherein the non-image areas of the coating of an exposed precursor are removed by applying the developer.

3. Process according to claim 1, wherein the aqueous composition is an aqueous gumming composition further comprising at least one member selected from surfactants and hydrophilic film-forming polymers, and wherein the gumming composition is applied to an imaged lithographic printing plate.

4. Process according to any one of claims 1 to 3, wherein the aqueous composition additionally comprises
at least one member selected from biocides, complexing agents, antifoaming agents, coloring agents, organic solvents, buffering agents, and preservatives.

5. Process according to any one of claims 1 to 4, wherein the inorganic, non-metallic, inert particles have an average particle size of 10 to 350 nm.

6. Process according to any of claims 1 to 5, wherein the inorganic, non-metallic, inert particles are composed of silica, alumina or titanium dioxide.

7. Process according to claim 2, wherein the amount of the inorganic, non-metallic, inert particles in the developer composition is from 2 to 20 wt% based on the total weight of the developer.

8. Process according to claim 3, wherein the amount of the inorganic, non-metallic, inert particles in the gumming composition is from 0.5 to 20 wt% based on the total weight of the gumming composition.

9. Process according to claim 3, wherein the gumming composition comprises a hydrophilic film-forming polymer selected from gum arabic, pullulan, cellulose derivatives, starch derivatives, poly(vinyl alcohol), poly(vinyl pyrrolidone), polyhydroxy compounds, homo- and copolymers of acrylic acid, methacrylic acid or acrylamide, copolymers of vinyl methyl ether and maleic anhydride, copolymers of vinyl acetate and maleic anhydride, copolymers of styrene and maleic anhydride, and polymers comprising amino groups, as well as acid groups and optionally alkylene oxide units.

10. Process according to claim 3, wherein the imaged lithographic printing plate has already been used for printing prior to applying the gumming composition.

11. Process according to claim 3, wherein the imaged lithographic printing plate is treated with the gumming composition immediately after imaging.

12. Process according to any of claims 1 to 9, wherein the lithographic printing plate precursor is an IR-sensitive precursor.

13. Aqueous composition comprising
(a) water
(b) at least one hydrophilic film-forming polymer and/or surfactant
(c) inorganic, non-metallic, inert particles having an average particle size of from 1 nm to 0.5 µm, and optionally
(d) at least one member selected from surfactants, biocides, complexing agents, antifoaming agents, coloring agents, organic solvents, buffering agents and preservatives.

14. Use of an aqueous composition as defined in any one of claims 1 to 9 and 13 for improving the scratch-resistance of lithographic printing plates.

15. Process for improving the scratch-resistance of a lithographic printing plate, comprising:
imagewise applying image areas to a substrate with hydrophilic surface, and
applying an aqueous composition comprising inorganic, non-metallic, inert particles having an average particle size of from 1 nm to 0.5 µm to the obtained lithographic printing plate.
